(19)

Europäisches Patentamt
European Patent Office
Office européen des brevets

(11) **EP 1 832 351 B1**

(12) **EUROPEAN PATENT SPECIFICATION**

(45) Date of publication and mention
of the grant of the patent:
**12.11.2008 Bulletin 2008/46**

(51) Int Cl.:
*B05D 3/06* (2006.01)  *C23C 16/40* (2006.01)
*C08J 9/26* (2006.01)  *H01B 3/46* (2006.01)

(21) Application number: **07012503.4**

(22) Date of filing: **26.03.2004**

(54) **Low dielectric materials and methods for making same**

Materialien mit niedriger Dielektrizitätskonstante und Herstellungsverfahren dafür

Matériaux à constante diélectrique faible et leur procédé de fabrication

(84) Designated Contracting States:
**AT BE BG CH CY CZ DE DK EE ES FI FR GB GR HU IE IT LI LU MC NL PL PT RO SE SI SK TR**

(30) Priority: **01.04.2003 US 404195**

(43) Date of publication of application:
**12.09.2007 Bulletin 2007/37**

(62) Document number(s) of the earlier application(s) in accordance with Art. 76 EPC:
**04007396.7 / 1 464 410**

(73) Proprietor: **Air Products and Chemicals, Inc.**
**Allentown, PA 18195-1501 (US)**

(72) Inventors:
• **Collins, Martha, Jean**
 **Allentown**
 **PA 18103 (US)**
• **Deis, Lisa, A.**
 **Pittsburgh, PA 15146 (US)**

• **Kirner, John, Francis**
 **Orefield**
 **PA 18069 (US)**
• **MacDougall, James, Edward**
 **New Tripoli**
 **PA 18066 (US)**
• **Peterson, Brian, Keith**
 **Fogelsville**
 **PA 18051 (US)**
• **Weigel, Scott, Jeffrey**
 **Allentown**
 **PA 18104 (US)**

(74) Representative: **Kador & Partner**
 **Corneliusstrasse 15**
 **80469 München (DE)**

(56) References cited:
 **EP-A- 1 369 907**      **EP-A- 1 376 671**
 **EP-A- 1 457 583**      **WO-A-20/04038783**
 **US-A1- 2002 123 240**

EP 1 832 351 B1

**Description**

BACKGROUND OF THE INVENTION

The present invention relates generally to materials suitable for use in electronic devices. More specifically, the invention relates to a material and film comprising same having an improved elastic modulus and a low dielectric constant and to a mixture and a method for making same.

There is a continuing desire in the microelectronics industry to increase the circuit density in multilevel integrated circuit devices such as memory and logic chips in order to improve the operating speed and reduce power consumption. In order to continue to reduce the size of devices on integrated circuits, it has become necessary to use insulators having a low dielectric constant to reduce the resistance-capacitance ("RC") time delay of the interconnect metallization and to prevent capacitive crosstalk between the different levels of metallization. Such low dielectric materials are desirable for premetal dielectric layers and interlevel dielectric layers.

Typical dielectric materials for devices with 180 nm line width are materials with a dielectric constant between about 3.8 and 4.2. As the line width decreases, the dielectric constant should also be decreased. For example, devices with 130 nm line width require materials with a dielectric constant between about 2.5 and 3.0. Extremely low dielectric constant ("ELK") materials generally have a dielectric constant between about 2.0 and 2.5. Devices with 90 nm line width require materials with dielectric constants less than 2.4. According to the 2001 International Technology roadmap for Semiconductors (ITRS) interconnect roadmap, the projected dielectric constant requirements for interlevel metal insulators will be less than 2.1 for the 65 nm node, less than 1.9 for the 45 nm node, less than 1.7 for the 32 nm node, and less than 1.6 for the 22 nm node.

The dielectric constant (K) of a material generally cannot be reduced without a subsequent reduction in the mechanical properties, i.e., modulus, hardness, etc. Mechanical strength is needed for subsequent processing steps such as etching, CMP ("Chemical Mechanical Planarization"), and depositing additional layers such as diffusion barriers for copper, copper metal ("Cu"), and cap layers on the product. In some of these processes, temperature cycling of multiple layers may induce stresses due to the thermal coefficient of expansion mismatch between the different materials thereby causing cracking or delamination. Surface planarity is also required and may be maintained through controlling processing parameters such as those during the film formation process and also through CMP. Mechanical integrity, or stiffness, compressive, and shear strengths, may be particularly important to survive CMP. It has been found that the ability to survive CMP may be correlated with the elastic, or Young's, modulus of the material, along with other factors including polishing parameters such as the down force and platen speed. See, for example, Wang et al., "Advanced processing: CMP of Cu/low-K and Cu/ultralow-K layers", Solid State Technol., September, 2001; Lin et al., "Low- k Dielectrics Characterization for Damascene Integration", International Interconnect Technology Conference, Burlingame, CA, June, 2001. These mechanical properties are also important in the packaging of the final product.

A number of processes have been used for preparing low dielectric constant films. Chemical vapor deposition (CVD) and spin-on dielectric (SOD) processes are typically used to prepare thin films of insulating layers. Other hybrid processes are also known such as CVD of liquid polymer precursors and transport polymerization CVD. A wide variety of low κ materials deposited by these techniques have been generally classified in categories such as purely inorganic materials, ceramic materials, silica-based materials, purely organic materials, or inorganic-organic hybrids. Likewise, a variety of processes have been used for curing these materials to decompose and/or remove volatile components and substantially crosslink the films such as heating, treating the materials with plasmas, electron beams, or UV radiation.

Since the dielectric constant of air is nominally 1.0, one approach to reducing the dielectric constant of a material may be to introduce porosity. Porosity has been introduced in low dielectric materials through a variety of different means. A dielectric film when made porous may exhibit lower dielectric constants compared to a dense film, however, the elastic modulus of the film generally decreases with increasing porosity. Consequently, it may be impractical to use these low dielectric compositions due to the trade-off in dielectric constant with elastic modulus.

One concern in the production of low κ dielectric films is the processing or cycle time. The cure or anneal step, in which the coated substrate is typically heated to decompose and/or remove volatile components and substantially cross-link the film, is a significant source of production bottlenecks. The majority of low and ultralow dielectric constant films currently made have a cure step which ranges from greater than 30 minutes to 2 hours. Consequently, reduction of the cure step time would reduce the overall process time and achieve higher manufacturing throughput.

Another concern in the production of low κ dielectric films is the overall thermal budget. Various components of IC devices such as Cu metal lines can only be subjected to processing temperatures for short time periods before their performance deteriorates due to undesirable diffusion processes. Most processes for preparing silica-based low κ films require curing steps at temperatures of 450°C or higher and times of 30 minutes or longer. Significant advantages could result if the curing step could be carried out at significantly lower temperatures and or shorter times.

One method to process silica-based low κ films without effecting the thermal budget of the device is by exposure to electron beam ("e-beam") radiation. The electron beam radiation step may be in addition to, or in lieu, of a thermal cure step. It is believed that the e-beam exposure may improve the mechanical properties of the film by removing most or all of the organic species from the film. For example, U.S. Pat. No. 6,042,994 describes a process wherein a nanoporous dielectric coated substrate is treated with a large area electron beam exposure system. The '994 patent contends based upon FTIR data that the e-beam cure has removed most of the organic species from the film. WO 97/00535 teaches a process for curing a dielectric material such as a spin-on-glass (SOG) having about 10-25% organic groups by exposure to e-beam irradiation. Using FTIR analysis, the WO 97/00535 application reports that there are no longer CH groups attached to the backbone of SOG starting compounds after curing with e-beam radiation. Further, U.S. Pat. No. 6,132,814 teaches curing a SOG layer by irradiating the layer with a large-area electron beam at a dose sufficient to cure the layer, wherein the irradiating step results in the expulsion of carbon organic groups from the layer.

The article, Kloster, G., et. al., "Porosity Effects on Low- κ Dielectric Film Strength and Interfacial Adhesion" and related slides presented at the International Interconnect Technology Conference on June 5, 2002 (referred to herein collectively as Kloster) describe treating porous, low-K organosiloxane films with e-beam radiation to improve the mechanical properties of the film by inducing microscopic $Si-CH_2-Si$ crosslinking. Kloster reports, however, that while the mechanical properties of the film are improved, the dielectric constant may increase. Further, Kloster reports a 25-50% depletion of carbon within the film. U. S. Patent Application 2001/0018129, teaches the formation of Si-C-Si bonds by irradiating a silica-based film with electron beams to provide a film with a dielectric constant of 3 or lower. However, unlike the '994 patent, the application teachs that the resultant film has a carbon content ranging from 5 to 17 mole %.

The non prepublished document EP-A-1369907 discloses a film with a normalized modulus of 52, but an dielectric constant of 1.67. The non prepublished document EP-A-1376671 describes dielectric films with a normalized modulus of 18.

Accordingly, there is a need in the art to provide improved dielectric materials having low dielectric constant and sufficient mechanical strength. There is also a need in the art to provide dielectric materials and films that have relatively low metal content yet still maintain the beneficial properties, i.e., lower κ and higher modulus, that high levels of metals may impart. Further, there is a need in the art to provide processes for making low dielectric films at relatively low temperatures and relatively short cycle times.

BRIEF SUMMARY OF THE INVENTION

In one aspect of the present invention, there is provided a process for forming a dielectric material comprising exposing a porous material comprising at least one silica source having at least one silicon atom and an organic group comprising carbon and hydrogen atoms attached thereto to an ionizing radiation source sufficient to remove at least a portion of the hydrogen atoms within the porous film and provide the dielectric material wherein the dielectric material has one or more bond types selected from the group consisting of silicon-carbon bonds, carbon-carbon bonds, silicon-oxygen bonds, and silicon-hydrogen bonds.

This aspect of the invention will become apparent from the following detailed description.

BRIEF DESCRIPTION OF SEVERAL VIEWS OF THE DRAWINGS

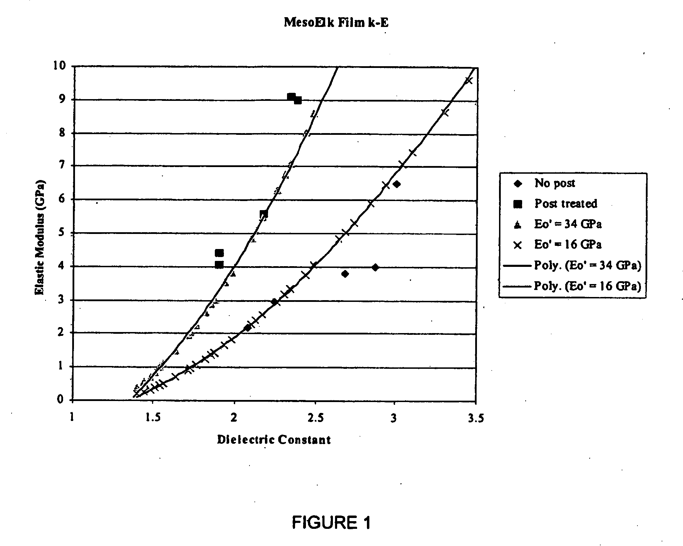

Figure 1 illustrates the relationship between dielectric constant and elastic modulus for various films of the present invention before and after exposure to electron beam irradiation compared to normalized elastic wall modulus $(E_0')$.

DETAILED DESCRIPTION OF THE INVENTION

The present invention is directed to low dielectric materials and films and methods for making and using same. The process of the present invention provides a method for preparing a porous, low dielectric film that may exhibit, *inter alia,* improved mechanical properties, thermal stability, and chemical resistance to oxygen or aqueous oxidizing environments relative to other porous dielectric materials of the art. Unlike prior art methods, the method of the present invention improves the mechanical and other properties of the material with significant retention of the carbon within the film. The terms "dielectric film" and "dielectric material" are used interchangeably throughout this specification.

In one embodiment of the present invention, a mixture, containing a silica source having at least one silicon atom and an organic group comprising carbon and hydrogen atoms attached to the silicon atom and a porogen, is cured thermally or by other means to substantially remove the porogen contained therein and form a porous material. Afterwards, the porous material is exposed to one or more ionizing radiation sources. The term "porous film" or "porous material" as used herein may describe closed, open, or interconnected porosity. While not intending to be bound by theory, the exposure to the ionizing radiation source removes at least a portion of the hydrogen contained within the porous material and forms a radical intermediate. This radical intermediate reacts with the Si atom and/or the C atom to form at least one bond such as a silicon-carbon bond, silicon-hydrogen bond, carbon-carbon bond, or silicon-oxygen bond and provide the dielectric material. The resultant dielectric material remains porous but has improved mechanical and other properties as a result of the exposure to the ionizing radiation source. Preferably, the dielectric constant of the dielectric material remains the same as, or is lower than, that of the porous material.

As mentioned previously, it is advantageous to impart porosity to a material to reduce its dielectric constant. However, once a material with the desired amount of porosity and dielectric constant is obtained, it is difficult to improve its mechanical properties, i.e., hardness and elastic modulus. The present invention provides a way to improve the hardness of the material and modulus of the material while maintaining or lowering its dielectric constant. While not intending to be bound by theory, it is believed that exposure of a silica-based porous material, having an organic species having a carbon and hydrogen bonded thereto, to an ionizing radiation source such as an electron beam may promote the removal of hydrogen atoms therby forming radical intermediates. In embodiments wherein the organic species bound source is a methyl group, this radical intermediate forms cross-links with other radical intermediates to provide the following products: Si-CH$_2$-CH$_2$-Si, Si-CH$_2$-Si, and Si-O-Si. Exposure of the coupled products to the ionizing radiation removes additional hydrogen from these products and forms further radical intermediates which cross-link with each other and other species. In this manner, the porosity of the material is substantially unchanged but the mechanical properties of the material is improved.

It is believed that the location, molar ratio, and type of organic species within the film forming mixture may be optimized to foster a greater degree of connectivity and cross-linking upon exposure to ionizing radiation source. A further aspect of integrating the exposure step to the film-forming material is that higher overall connectivity can be obtained by integrating the exposure step with film forming mixtures containing organic groups that when exposed to ionizing radiation are susceptible to the removal of hydrogen atoms to form radical intermediates that can subsequently cross-link than the connectivity that can be obtained using either the standard thermal cure process with those organic groups or exposure to ionizing radiation without those organic groups. Furthermore, if the organic species is a methyl group, the conversion of $\equiv$Si-CH$_3$ may depend on the fraction of methyl groups that are in close enough proximity to cross-link if radicals form in the electron beam. Lower methyl contents, however, may make it unlikely that all methyl groups have a methyl neighbor to form the product Si-CH$_2$-CH$_2$-Si upon exposure.

In certain preferred embodiments, the dielectric material of the present invention may have improved mechanical and other properties as a result of the exposure to the ionizing radiation source. The improvement in properties may be expressed by the normalized wall elastic modulus ($E_0'$). Pending U. S. Pat. Application Serial No. 10/158,511 which is incorporated herein by reference in its entirety, discusses the normalized wall elastic modulus ($E_0'$) and its relationship on the material properties. Two measured attributes of a low dielectric material, dielectric constant and elastic modulus, are correlated into one figure of merit, the normalized wall elastic modulus ($E_0'$), that can be used to identify and develop improved low dielectric materials. Improved dielectric materials are materials having a low dielectric constant yet high enough elastic modulus to tolerate subsequent processing steps such as packaging and CMP processes. In this connection, materials with substantially identical normalized wall elastic modulus values belong to a family of materials whose dielectric constant and elastic modulus can be adjusted by varying the porosity. Thus, once an improved dielectric material is identified, i.e. one with a higher normalized wall elastic modulus, the target dielectric constant can be obtained by varying the porosity.

The term "normalized wall elastic modulus", as used herein, is the wall elastic modulus of a material that is normalized to a wall with a dielectric constant of 4.2, which is the dielectric constant of a SiO$_2$ dense oxide material. Once the dielectric constant ($\kappa$) and the elastic modulus (E) of a material are measured, the normalized wall elastic modulus ($E_0'$) can be calculated. The $E_0'$ of the material is calculated using Maxwell's relationship for mixed dielectrics applied to porous materials, the measured value for dielectric constant ($\kappa$), a wall $\kappa_{SiO2}$ of 4.2, Day's 2-d circular hole model for elastic modulus extended to 3-d cylindrical pores with the modulus measured perpendicular to the pore axes, and the measured value for E. While the derivation for the normalized wall elastic modulus is based upon cylindrical pores in the extension of the Day model and spherical inclusions in the Maxwell model, it is anticipated that other types and forms or porosity, i.e., non-cylindrical, open porosity, closed porosity, etc., would fall within the scope of the present invention.

A void fraction value is first calculated from the Maxwell equation using the observed value for $\kappa$ of the material and a value for the wall $\kappa$ of 4.2, corresponding to the dielectric constant of dense, amorphous silica. The dielectric constant of the material is preferably less than 4.2 since $\kappa_{SiO2}$ is 4.2. The Maxwell equation was rearranged to solve for porosity or void fraction, as a function of measured $\kappa$ and wall $\kappa$, as provided in Equation (1):

$$\chi_p = \frac{\left[\dfrac{2}{3} + \dfrac{1}{3 \times \kappa_{SiO2}}\right] \times (\kappa_{SiO2} - \kappa)}{\left[\dfrac{2}{3} + \dfrac{1}{3 \times \kappa_{SiO2}}\right] \times (\kappa_{SiO2} - \kappa) + \kappa - 1} \qquad \text{Equation (1)}$$

where:

$$\kappa_{SiO2} = 4.2$$

where:

$\kappa_{SiO2} = 4.2$

$\chi_p$ = void fraction value

$\kappa$ = measured value of dielectric constant

The normalized wall elastic modulus may then be calculated based on Day's 2-d circular hole model for elastic modulus using Equation (2). The equation is valid for void fractions less than $q_c$, the critical porosity at which the pores touch, and beyond which the modulus is predicted to be zero. For materials with a wall $\kappa$ of 4.2, this determines a minimum $\kappa$ value = 1.23 for composites with E > 0.

Day et al. 2-d circular hole model:

$$\frac{E_{2d}^{\bullet}}{E_0} = \left[\left(\frac{1 - q/q_c}{1 + q/mq_I}\right)\left(1 + \frac{q}{q_c} + \alpha\theta\left(\frac{q}{q_c}\right)^2 + \alpha(1-\theta)\left(\frac{q}{q_c}\right)^3\right)\right]^m \quad \text{Equation (2)}$$

where

q = void fraction

$q_c$ = 0.9069 = percolation threshold, void fraction at which circles overlap and modulus goes to zero

$q_I$= 1/3 = initial slope

m = 1.5 = critical exponent

$\alpha$ = -0.251 = parameter to get correct critical amplitude

$\theta$= -1.83 = free fitting parameter

The Day 2-d circular hole model for elastic modulus is extended to 3-d cylindrical pores with the modulus measured perpendicular to the pore axes as provided in the Equation (3). The normalized wall elastic modulus can be calculated using the calculated void fraction value from Equation (1), the elastic modulus for 2-d circular holes from Equation (2), the observed value for E, and a value for Poisson's ratio (v) of 0.25.

3-d extension perpendicular to the cylinders:

$$\frac{E_0}{E_{3d\perp}^{\bullet}} = \frac{v^2}{1-q} + \frac{1-v^2}{E_{2d}^{\bullet}/E_0} \qquad \text{Equation (3)}$$

where

v = Poisson's ratio = 0.25

q = void fraction

$E_0$ = wall elastic modulus

When q is set equal to the void fraction value $\chi_p$ obtained from the measured value of $\kappa$ and Equation (1), and $E_{3d\perp}^{\bullet}$ is set equal to the measured value of elastic modulus, E, then $E_0$ becomes $E_0$', the normalized wall elastic modulus, giving the following equation, Equation (4), for $E_o$':

$$E_0' = E \times \left[ \frac{\nu^2}{1-q} + \left(1-\nu^2\right) \times \left[ \left( \frac{1-q/q_c}{1+q/mq_l} \right) \left( 1 + \frac{q}{q_c} + \alpha\theta \left( \frac{q}{q_c} \right)^2 + \alpha\left(1-\theta\right) \left( \frac{q}{q_c} \right)^3 \right) \right]^{-m} \right] \quad \text{Equation (4)}$$

The low dielectric material of the present invention has a dielectric constant of about 3.7 or less. In certain embodiments, the dielectric material may have a dielectric contant that ranges from 2.1. to 3.7. In these embodiments, the low dielectric material of the present invention has a normalized wall elastic modulus ($E_0'$) of about 32 GPa or greater, and more preferably about 37 GPa or greater. Further, in some embodiments of the present invention, the materials have alkali impurity levels less than about 500 ppm.

The material of the present invention may be formed into a film from a precursor composition or mixture using a variety of different methods. Some examples of processes that may be used to form the film include plasma enhanced chemical vapor deposition ("PECVD"), high density PECVD, photon assisted CVD, plasma-photon assisted CVD ("PPECVD"), CVD of a liquid polymer precursor, or transport polymerization ("TP"). U. S. Pat. Nos. 6,171,945 and 6,054,206 provide some exemplary CVD methods that may be used with the present invention. Other processes that can be used to form the film include spin-on deposition methods. In certain embodiments of the present invention, non-contact induced spreading forces such as the process described in pending U.S. Pat. Appication Attorney's Docket 2001-030 - SMX 3122 entitled "Apparatus and Methods for Forming Films on Substrates", may be used to apply the mixture. Further related processes may be used to apply the mixture include oscillating non-contact induced spreading forces, gravity-induced spreading forces, wetting-induced spreading forces, or combinations thereof.

The materials of the present invention preferably comprise silica. The term "silica" or "silica based", as used herein, is a material that has silicon (Si) and oxygen (O) atoms, and possibly additional substituents such as, but not limited to, other elements such as H, B, C, P, or halide atoms or organic groups such as alkyl groups or aryl groups. Preferably, the materials of the present invention have at least one silica source having an organic group comprising carbon and hydrogen attached to the silicon atom. In certain preferred embodiments, the material may have a mole ratio of the total number of Si-C bonds to the total number of Si atoms of 0.2 mole ratio or greater, preferably ranging from about 0.2 to about 3 mole ratio, or more preferably ranging from about 0.6 to about 3 mole ratio.

The film of the present invention is preferably formed from a mixture. The mixture may be prepared prior to forming the film or the mixture may form during at least a portion of the film forming process. The mixture comprises the film matrix material, a porogen, and other additives that vary depending which formation process is used. Depending upon the film formation method, the mixture may bedeposited onto a substrate as a liquid, vapor, gas, or aerosol of the mixture.

As mentioned previously, the mixture generally comprises the matrix material, preferably a silica-containing matrix material and a porogen. The mixture may further include other constituents such as, but not limited to, water, solvent(s), and/or ionic additives. The weight ratio of weight of porogen to the weight of porogen and weight of $SiO_2$ ranges from 0.85 to 0.1, more preferably 0.75 to 0.2. The weight of $SiO_2$ is calculated from the total number of moles of silicon introduced by the silica sources within the mixture. This is not meant to imply that the silica sources are completely converted to $SiO_2$. The weight ratio of solvent to silica is about 30:1 wherein the solvent may include water. The weight ratio of weight of porogen to the weight of porogen and the weight of $SiO_2$ provided by the silica source is 0.4 or greater, preferably 0.5 or greater, and more preferably 0.6 or greater. The weight ratio of base to weight of porogen is 0.5 to 0. The molar ratio of R, or organic constituents, to Si ranges from 0.2 to 3, preferably 0.6 to 3. The molar ratio of water to OR, where OR is an organic group bonded to silicon through an oxygen atom, e.g. ethoxy functionality on TEOS, ranges from 40 to 1.

At least one of the silica sources within the mixture has at least one organic group bonded to the silicon atom that is susceptible to the removal of hydrogen upon exposure to an ionizing radiation source. Preferably, the silicon atom has one methyl group bonded to the silicon atom such as the compounds methyltriethoxysilane (MTES) or methytriacetoxysilane (MTAS). Alternatively, the silicon atom may have more than one methyl group bonded to the silicon atom such as the compounds dimethyldiethoxysilane (DMDES) or tetraethoxydimethyldisiloxane (TEDMDS).

The mixture employs chemicals that meet the requirements of the electronics industry because they do not contain contaminants which reduce the efficiency of preparation of integrated circuits. Constituents like halogen-containing mineral acids, cationic surfactants with halide counter ions, and anionic surfactants with alkali metal counter ions are preferably avoided in the mixture because they may contribute undesirable counter ions to the materials of the invention. The mixtures of the present invention preferably contain contaminating metals in amounts less than 500 parts per million ("ppm"), preferably less than 100 parts per billion ("ppb"), and more preferably less than 10 ppb. Consequently, materials of the invention may preferably contain contaminating metals in amounts less than 500 parts per million ("ppm"), preferably less than 100 parts per billion ("ppb"), and more preferably less than 10 ppb. Materials of the invention preferably contain contaminating halides in amounts less than 1 ppm, preferably less than 750 ppb, and more preferably less than 500 ppb.

As mentioned previously, the mixture comprises at least one silica source. A "silica source", as used herein, is a compound having silicon (Si) and oxygen (O) and possibly additional substituents such as, but not limited to, other elements such as H, B, C, P, or halide atoms and organic groups such as alkyl groups; or aryl groups. The silica source has an organic group attached to the silicon atom. The term "alkyl" as used herein includes linear, branched, or cyclic alkyl groups, containing from 1 to 24 carbon atoms, preferably from 1 to 12 carbon atoms, and more preferably from 1 to 5 carbon atoms. This term applies also to alkyl moieties contained in other groups such as haloalkyl, alkaryl, or aralkyl. The term "alkyl" further applies to alkyl moieties that are substituted, for example with carbonyl functinality. The term "aryl" as used herein six to twelve member carbon rings having aromatic character. The term "aryl" also applies to aryl moieties that are substituted. The silica source may include materials that have a high number of Si-O bonds, but can further include Si-O-Si bridges, Si-R-Si bridges, Si-C bonds, Si-H bonds, Si-F bonds, or C-H bonds. It is preferred that the at least one silica source imparts a minimum of Si-OH bonds in the dielectric material. The silica source may further include residual components from processing, such as organics, that were not removed after formation of the porous material.

The following are non-limiting examples of silica sources suitable for use in the mixture and method of the present invention. In the chemical formulas which follow and in all chemical formulas throughout this document, the term "independently" should be understood to denote that the subject R group is not only independently selected relative to other R groups bearing different superscripts, but is also independently selected relative to any additional species of the same R group. For example, in the formula $R_aSi(OR^1)_{4-a}Si$, when a is 2 or 3, the two or three R groups need not be identical to each other or to $R^1$.

Other examples of the at least one silica source may include a fluorinated silane or fluorinated siloxane such as those provided in U. S. Pat. No. 6,258,407.

Another example of at least one silica source may include compounds that produce a Si-H bond upon elimination.

Still further examples of the at least one silica source are found in the the non-hydrolytic chemistry methods described, for example, in the references Hay et al., "Synthesis of Organic-Inorganic Hybrids via the Non-hydrolytic Sol-Gel Process", Chem. Mater., 13, 3396-3403 (2001) or Hay, et al., "A Versatile Route to Organically-Modified Silicas and Porous Silicas via the Non-Hydrolytic Sol-Gel Process", J. Mater. Chem., 10, 1811-1818 (2000).

Yet another example of at least one silica source may include colloidal silica, fumed silica, or silicic acid starting materials.

Still other examples of silica sources include silsesquioxanes such as hydrogen silsesquioxanes (HSQ, $HSiO_{1.5}$) and methyl silsesquioxanes (MSQ, $RSiO_{1.5}$ where R is a methyl group). Further examples of the suitable silica sources include those described in U. S. Pat. No. 6,271,273 and EP Nos. 1,088,868; 1,123,753, and 1,127,929.

As mentioned previously, at least one of the silica sources within the mixture is a compound which has at least one silicon atom that has an organic group comprising carbon and hydrogen atoms attached thereto. In preferred embodiments, the compound may be represented by the following: $R_aSi(OR^1)_{4-a}$, wherein R and $R^1$ can be independently the same or different; R represents a hydrogen atom or a monovalent organic group; $R^1$ represents a monovalent organic group; and a is an integer ranging from 1 to 3; or $R^3_b(R^4O)_{3-b}Si-(R^7)-Si(OR^5)_{3-c}R^6_c$, wherein $R^3$ and $R^6$ can be independently the same or different and each represents a hydrogen atom or a monovalent organic group; $R^4$ and $R^5$ can be independently the same or different and each represents a monovalent organic group; b and c can be independently the same or different and each is a number ranging from 0 to 3; $R^7$ represents an oxygen atom, a phenylene group, or a group represented by $-(CH_2)_n-$, wherein n is an integer ranging from 1 to 6; or combinations thereof.

The term "monovalent organic group" as used herein relates to an organic group bonded to an element of interest, such as Si or O, through a single C bond, i.e., Si-C or O-C. Examples of monovalent organic groups include an alkyl or an aryl group. The alkyl group may be a linear, branched, or cyclic alkyl group having from 1 to 5 carbon atoms such as, for example, a methyl, ethyl, propyl, butyl, or pentyl group. In certain embodiments, one or more hydrogens within the alkyl group may be substituted with an additional atom such as a halide atom (i.e., fluorine), or an oxygen atom to give a carbonyl functionality. Examples of aryl groups suitable as the monovalent organic group include phenyl, methylphenyl, ethylphenyl and fluorophenyl.

Specific examples of the compounds represented by $R_aSi(OR^1)_{4-a}$ wherein R and $R^1$ are each independently the same or different and at least one of R is a monovalent organic group include: methyltrimethoxysilane, methyltriethoxysilane, methyltri-n-propoxysilane, methyltri-iso- propoxysilane, methyltri-n-butoxysilane, methyltri-sec-butoxysilane, methyltri-tert-butoxysilane, methyltriacetoxysilane, methyltriphenoxysilane, ethyltrimethoxysilane, ethyltriethoxysilane, ethyltri-n-propoxysilane, ethyltri-iso-propoxysilane, ethyltri-n-butoxysilane, ethyltri-sec-butoxysilane, ethyltri-tert-butoxysilane, ethyltriacetoxysilane, ethyltriphenoxysilane, n-propyltrimethoxysilane, n-propyltriethoxysilane, n-propyltri-n- propoxysilane, n-propyltri-iso-propoxysilane, n-propyltin-n-butoxysilane, n-propyltri-sec-butoxysilane, n-propyltri-tert-butoxysilane, n-propyltriacetoxysilane, n-propyltriphenoxysilane, isopropyltrimethoxysilane, isopropyltriethoxysilane, isopropyltri-n-propoxysilane, isopropyltriisopropoxysilane, isopropyltri-n-butoxysilane, isopropyltri-sec-butoxysilane, isopropyltri-tert-butoxysilane, isopropyltriacetoxysilane, isopropyltriphenoxysilane, nbutyltrimethoxysilane, n-butyltriethoxysilane, n-butyltri-n-propoxysilane, nbutyltriisopropoxysilane, n-butyltri-n-butoxysilane, n-butyltri-sec-butoxysilane, n-butyltri-tert-butoxysilane, n-butyltriacetoxysilane, n-butyltriphenoxysilane; secbutyltrimethoxysilane, sec-butyltriethoxysilane, sec-butyltri-n-propoxysilane, secbutyltriisopropoxysilane, sec-butyltri-n-butoxysilane, sec-butyltri-sec-butoxysilane, secbutyltri-tert-butoxysilane, sec-butyltriacetoxysilane, sec-butyltriphenoxysilane, tertbutyltrimethoxysilane, tert-butyltriethoxysilane, tert-butyltri-n-propoxysilane, tertbutyltriisopropoxysilane, tert-butyltri-n-butoxysilane, tert-butyltri-sec-butoxysilane, tertbutyltri-tert-butoxysilane, ert-butyltriacetoxysilane, tert-butyltriphenoxysilane, isobutyltrimethoxysilane, isobutyltriethoxysilane, isobutyltri-n-propoxysilane, isobutyltriisopropoxysilane, isobutyltri-n-butoxysilane, isobutyltri-sec-butoxysilane, isobutyltri-tert-butoxysilane, isobutyltriacetoxysilane, isobutyltriphenoxysilane, npentyltrimethoxysilane, n-pentyltriethoxysilane, n-pentyltri-n-propoxysilane, npentyltriisopropoxysilane, n-pentyltri-n-butoxysilane, n-pentyltri-sec-butoxysilane, npentyltri-tert-butoxysilane, n-pentyltriacetoxysilane, n-pentyltriphenoxysilane; secpentyltrimethoxysilane, sec-pentyltriethoxysilane, sec-pentyltri-n-propoxysilane, sec-pentyltriisopropoxysilane, sec-pentyltri-n-butoxysilane, sec-pentyltri-sec-butoxysilane, sec-pentyltri-tert-butoxysilane, sec-pentyltriacetoxysilane,sec-pentyltriphenoxysitane, tert-pentyltrimethoxysilane, tert-pentyltriethoxysilane, tert-pentyltri-n-propoxysilane, tert-pentyltriisopropoxysilane, tert-pentyltri-n-butoxysilane, tert-pentyltri-sec-butoxysilane, tert-pentyltri-tert-butoxysilane, tert-pentyltriacetoxysilane, tert-pentyltriphenoxysilane, isopentyltrimethoxysilane, isopentyltriethoxysilane, isopentyltri-n-propoxysilane, isopentyltriisopropoxysilane, isopentyltri-n-butoxysilane, isopentyltri-sec-butoxysilane, isopentyltri-tert-butoxysilane, isopentyltriacetoxysilane, isopentyltriphenoxysilane, neo-pentyltrimethoxysilane, neo-pentyltriethoxysilane, neo-pentyltri-n-propoxysilane, neo-pentyltriisopropoxysilane, neo-pentyltri-n-butoxysilane, neo-pentyltri-sec-butoxysilane, neo-pentyltri-neo-butoxysilane, neopentyltriacetoxysilane, neo-pentyltriphenoxysilane phenyltrimethoxysilane, phenyltriethoxysilane, phenyltri-n-propoxysilane, phenyltriisopropoxysilane, phenyltri-n-butoxysilane; phenyltri-sec-butoxysilane, phenyltri-tert-butoxysilane, phenyltriacetoxysilane, phenyltriphenoxysilane, δ-trifluoropropyltrimethoxysilane δ-trifluoropropyltriethoxysilane, dimethyldimethoxysilane, dimethyldiethoxysilane, dimethyldi-n-propoxysilane, dimethyldiisopropoxysilane, dimethyldi-n-butoxysilane, dimethyldi-sec-butoxysilane, dimethyldi-tert-butoxysilane, dimethyldiacetoxysilane, dimethyldiphenoxysilane, diethyldimethoxysilane, diethyldiethoxysilane, diethyldi-n-propoxysilane, diethyldiisopropoxysilane, diethyldi-n-butoxysilane, diethyldi-sec-butoxysilane, diethyldi-tert-butoxysilane, diethyldiacetoxysilane, diethyldiphenoxysilane, di-n-propyldimethoxysilane, di-n-propyldimethoxysilane, di-n-propyldi-n-propoxysilane, di-n-propyldiisopropoxysilane, din-propyldi-n-butoxysilane, di-n-propyldi-sec-butoxysilane, di-n-propyldi-tert-butoxysilane, di-n-propyldiacetoxysilane, di-n-propyldiphenoxysilane, diisopropyldimethoxysilane, diisopropyldiethoxysilane, diisopropyldi-n-propoxysilane, diisopropyldiisopropoxysilane, diisopropyldi-n-butoxysilane, diisopropyldi-sec-butoxysilane, diisopropyldi-tert-butoxysilane, diisopropyldiacetoxysilane, diisopropyldiphenoxysilane, di-n-butyldimethoxysilane, di-n-butyldiethoxysilane, di-n-butyldi-n-propoxysilane, di-n-butyldiisopropoxysilane, di-n-butyldi-n-butoxysilane, di-n-butyldi-sec-butoxysilane, di-n-butyldi-tert-butoxysilane, di-n-butyldiacetoxysilane, di-n-butyldiphenoxysilane, di-sec-butyldimethoxysilane, di-sec-butyldiethoxysilane, di-sec-butyldi-n-propoxysilane, di-sec-butyldiisopropoxysilane, di-sec-butyldi-n-butoxysilane, di-sec-butyldi-sec-butoxysilane, di-sec-butyldi-tert-butoxysilane, di-sec-butyldiacetoxysilane, di-sec-butyldiphenoxysilane, di-tert-butyldimethoxysilane, di-tert-butyldiethoxysilane, di-tert-butyldi-n-propoxysilane, di-tert-butyldiisopropoxysilane, di-tert-butyldi-n-butoxysilane, di-tert-butyldi-sec-butoxysilane, di-tert-butyldi-tert-butoxysilane, di-tert-butyldiacetoxysilane, di-tert-butyldiphenoxysilane, diphenyldimethoxysilane, diphenyldiethoxysilane, diphenyldi-n-propoxysilane, diphenyldiisopropoxysilane, diphenyldi-n-butoxysilane, diphenyldi-sec-butoxysilane, diphenyldi-tert-butoxysilane, diphenyldiphenoxysilane, methylneopentyldimethoxysilane, methylneopentyidiethoxysilane, methyldimethoxysilane, ethyldimethoxysilane, n-propyldimethoxysilane, isopropyldimethoxysilane, n-butyldimethoxysilane, sec-butyldimethoxysilane, tert-butyldimethoxysilane, isobutyldimethoxysilane, n-pentyldimethoxysilane, sec-pentyldimethoxysilane, tert-pentyldimethoxysilane, isopentyldimethoxysilane, neopentyldimethoxysilane, neohexyldimethoxysilane, cyclohexyldimethoxysilane, phenyldimethoxysilane, methyldiethoxysilane, ethyldiethoxysilane, n-propyldiethoxysilane, isopropyldiethoxysilane, n-butyldiethoxysilane, sec-butyldiethoxysilane, tert-butyldiethoxysilane, isobutyldiethoxysilane, n-pentyldiethoxysilane, sec-pentyldiethoxysilane, tert-pentyldiethoxysilane, isopentyldiethoxysilane, neopentyldiethoxysilane, neohexyldiethoxysilane, cyclohexyldiethoxysilane, phenyldiethoxysilane, dimethylmethoxysifane, diethylmethoxysilane, di-n-propylmethoxysilane, diisopropylmethoxysilane, di-n-butylmethoxysilane, di-sec-butylmethoxysilane, di-tert-butylmethoxysilane, diisobutylmethoxysilane, di-n-pentylmethoxysilane, di-sec-pentylmethoxysilane, di-tert-pentylmethoxysilane, diisopentylmethoxysilane, dineopentylmethoxysilane, dineohexylmethoxysilane, dicyclohexylmethoxysilane, diphenylmethoxysilane, dimethylethoxysilane, diethylethoxysilane, di-n-propylethoxysilane, diisopropylethoxysilane, di-n-butylethoxysilane, di-sec-butylethoxysilane, di-tert-butylethoxysilane, diisobutylethoxysilane, di-n-pentylethoxysilane, di-sec-pentylethoxysilane, di-tert-pentylethoxysilane, diisopentylethoxysilane, dineopentylethoxysilane, dineohexylethoxysilane, dicyclohexylethoxysilane, and diphenylethoxysilane. Of the above compounds, the preferred compounds are methyltrimethoxysilane, methyltriethoxysilane, methyltri-n-propoxysilane, methyltriisopropoxysilane, ethyltrimethoxysilane, ethyltriethoxysilane, dimethyldimethoxysilane, dimethyldiethoxysilane, diethyldimethoxysilane, diethyldiethoxysilane, trimethylmonomethoxysilane, trimethylmonoethoxysilane, triethylmonomethoxysilane, and triethylmonoethoxysilane, . More preferably, R is - $CH_n(CR'_3)_{3-n}$ where $n = 0$ to 3, $R' \neq H$, R' can be any monovalent organic group, and can be the same or different. Of these, methyl and neopentyl are preferred. The above compounds may be used alone or as a mixture of two or more thereof.

Specific examples of the compounds represented by the formula $R^3_b(R^4O)_{3-b}Si-(R7)-Si(OR^5)_{3-c}R^6_c$ wherein $R_7$ is an oxygen atom include: 1,1,1,3,3-pentamethoxy-3-methyldisiloxane, 1,1,1,3,3-pentaethoxy-3-methyldisiloxane, 1,1,1,3,3-pentamethoxy-3-phenyldisiloxane, 1,1,1,3,3-pentaethoxy-3-phenyldisiloxane, 1,1,3,3-tetramethoxy-1,3-dimethyldisiloxane, 1,1,3,3-tetraethoxy-1,3-dimethyldisiloxane, 1,1,3,3-tetramethoxy-1,3-diphenyldisiloxane, 1,1,3,3-tetraethoxy-1,3-diphenyldisiloxane, 1,1,3-trimethoxy-1,3,3-trimethyldisiloxane, 1,1,3-triethoxy-1,3,3-trimethyldisiloxane, 1,1,3-trimethoxy-1,3,3-triphenyldisiloxane, 1,1,3-triethoxy-1,3,3-triphenydisiloxane, 1,3-dimethoxy-1,1,3,3-tetramethyldisiloxane, 1,3-diethoxy-1,1,3,3-tetramethyldisiloxane, 1,3-dimethoxy-1,1,3,3-tetraphenyldisiloxane and 1,3-diethoxy-1,1,3,3-tetraphenyldisiloxane. Of those, preferred compounds are 1,1,3,3-tetramethoxy-1,3-dimethyldisiloxane, 1,1,3,3-tetraethoxy-1,3-dimethyldisiloxane, 1,1,3,3-tetramethoxy-1,3-diphenyldisiloxane, 1,3-dimethoxy-1,1,3,3-tetramethyldisiloxane, 1,3-diethoxy-1,1,3,3-tetramethyldisiloxane, 1,3-dimethoxy-1,1,3,3-tetraphenyldisiloxane and 1,3-diethoxy-1,1,3,3-tetraphenyldisiloxane.

Specific examples of the compounds represented by the formula $R^3_b(R^4O)_{3-b}Si-(R^7)-Si(OR^5)_{3-c}R^6_c$ wherein $R_7$ is $-(CH_2)_n-$ include: bis(hexamethoxysilyl)methane, bis(hexaethoxysilyl)methane, bis(hexaphenoxysilyl)methane, bis(dimethoxymethylsilyl)methane, bis(diethoxymethylsilyl)methane, bis(dimethoxyphenylsilyl)methane, bis(diethoxyphenylsilyl)methane, bis(methoxydimethylsilyl)methane, bis(ethoxydimethylsilyl)methane, bis(methoxydiphenylsilyl)methane, bis(ethoxydiphenylsilyl)methane, bis(hexamethoxysilyl)ethane, bis(hexaethoxysilyl)ethane, bis(hexaphenoxysilyl)ethane, bis(dimethoxymethylsilyl)ethane, bis(diethoxymethylsilyl)ethane, bis(dimethoxyphenylsilyl)ethane, bis(diethoxyphenylsilyl)ethane, bis(methoxydimethylsilyl)ethane, bis(ethoxydimethylsilyl)ethane, bis(methoxydiphenylsilyl)ethane, bis(ethoxydiphenylsilyl)ethane, 1,3-bis(hexamethoxysilyl)propane, 1,3-bis(hexaethoxysilyl)propane, 1,3-bis(hexaphenoxysilyl)propane, 1,3-bis(dimethoxymethylsilyl)propane, 1,3-bis(diethoxymethylsilyl)propane, 1,3-bis(dimethoxyphenylsilyl)propane, 1,3-bis(diethoxyphenylsilyl)propane, 1,3-bis(methoxydimethylsilyl)propane, 1,3-bis(ethoxydimethylsilyl)propane, 1,3-bis(methoxydiphenylsilyl)propane and 1,3-bis(ethoxydiphenylsilyl) propane. Of those, preferred compounds are bis(hexamethoxysilyl)methane, bis(hexaethoxysilyl)methane, bis(dimethoxymethylsilyl)methane, bis(diethoxymethylsilyl)methane, bis(dimethoxyphenylsilyl)methane, bis(diethoxyphenylsilyl)methane, bis(methoxydimethylsilyl)methane, bis(ethoxydimethylsily)methane, bis(methoxydiphenylsilyl)methane and bis(ethoxydiphenylsilyl)methane.

In addition to the at least one silica sources wherein the silica source has at least one Si atom having an organic group comprising C and H atoms attached thereto, the mixture may further comprise additional silica sources that may not necessarily have an organic group attached to the Si atom. The mixture may further comprise a compound represented by the formula $Si(OR^2)_4$ wherein $R^2$ represents a monovalent organic group. Specific examples of the compounds represented by $Si(OR^2)_4$ include tetramethoxysilane, tetraethoxysilane, tetra-n-propoxysilane, tetraisopropoxysilane tetra-n-butoxysilane, tetra-sec-butoxysilane, tetra- tert-butoxysilane, tetraacetoxysilane, and tetraphenoxysilane. Of the above, the preferred compounds are tetramethoxysilane, tetraethoxysilane, tetra-n-propoxysilane, or tetraisopropoxysilane, tetraphenoxysilane.

The mixture may further comprise a compound represented by the formula $R_aSi(OR^1)_{4-a}$ wherein R represents a hydrogen atom, R' represents a monovalent organic group, and a is an integer that ranges from 1 to 3. Specific examples of the compounds represented by $R_aSi(OR^1)_{4-a}$ wherein R represents a hydrogen atom include trimethoxysilane, triethoxysilane, tri-n-propoxysilane, triisopropoxysilane, tri-n-butoxysilane, tri-sec-butoxysilane, tri-tert-butoxysilane, triphenoxysilane.

The mixture may further comprise a compound represented by the formula $R^3_b(R^4O)_{3-b}Si-O-Si(OR^5)_{3-c}R^6_c$, wherein $R^3$ and $R^6$ represent a hydrogen atom, $R^4$ and $R^5$ may be each independently the same or different and each represents a monovalent organic group, and b and c may be the same or different and each is a number ranging from 0 to 3. Specific examples of the compounds represented by this formula include hexamethoxydisiloxane, hexaethoxydisiloxane, and hexaphenoxydisiloxane.

Still further examples of other silica sources having an organic group bonded to the silicon atom include compounds wherein at least a portion of the organic group is unsaturated, i.e., has at least one C-C double bond. Examples of such compounds include: vinyltrimethoxysilane, vinyltriethoxysilane, vinyltri-n-propoxysilane, vinyltriisopropoxysilane, vinyltri-n-butoxysilane, vinyltri-sec-butoxysilane, vinyltri-tert-butoxysilane, vinyltriphenoxysilane, divinyldimethoxysilane, allyltrimethoxysilane, allyltriethoxysilane, allyltri-n-propoxysilane, allyltriisopropoxysilane, allyltri-n-butoxysilane, allyltri-sec-butoxysilane, allyltri-tert-butoxysilane, allyltriphenoxysilane, diallyldimethoxysilane, propenyltrimethoxysilane, propenyltriethoxysilane, propenyltri-n-propoxysilane, propenyltriisopropoxysilane, propenyltri-n-butoxysilane, propenyltri-sec-butoxysilane, propenyltri-tert-butoxysilane, propenyltriphenoxysilane, dipropenyldimethoxysilane, crotyltrimethoxysilane, crotyltriethoxysilane, crotyltri-n-propoxysilane, crotyltriisopropoxysilane, crotyltri-n-butoxysilane, crotyltri-sec-butoxysilane, crotyltri-tert-butoxysilane, crotyltriphenoxysilane, dicrotyldimethoxysilane, vinylmethyldimethoxysilane, and vinylmethydiethoxysilane.

Additional organic groups with carbon-carbon double bonds include acrylates, unsaturated polyesters, epoxies, and vinyl ethers. Examples of these species attached to Si include (3-acryloxypropyl)trimethoxysilane and methacryloxymethyltrimethoxysilane.

In preferred embodiments, a combination of hydrophilic and hydrophobic silica sources is used in the mixture. In preferred embodiments, the ratio of hydrophobic silica source to the total amount of silica source is greater than about 0.2 molar ratio, preferably from 0.2 to 3 molar ratio. The term "hydrophilic", as used herein, refers to compounds wherein the silicon atom can crosslink through at least four bonds. Some examples of hydrophilic sources include alkoxysilanes having an alkoxy functionality and can at least partially crosslink, i.e. a Si atom with four methoxy, ethoxy, propoxy, acetoxy, etc. groups, or materials with carbon or oxygen bonds between Si atoms and all other functionality on the Si atoms being an alkoxide. If the Si atoms do not fully crosslink, residual Si-OH groups may be present as terminal groups that can adsorb water. The term hydrophobic source refers to compounds where at least one of the alkoxy functionalities has been replaced with a terminal Si-C or Si-F bond, i.e. Si-methyl, Si-ethyl, Si-phenyl, Si-cyclohexyl, etc., that would not generate a hydroxyl after hydrolysis. In these sources, the silicon would crosslink with less than four bridges even when fully crosslinked as a result of hydrolysis and condensation of Si-OH groups if the terminal group remains intact. In certain preferred embodiments, the hydrophobic silica source contains a methyl group or neopentyl group attached to silicon. Under certain processing conditions, terminal organic groups may undergo beta hydride elimination to form Si-H bonds that may be oxidized to Si-OH and result in Si-O-Si bridges and/or residual Si-OH within the compound. In this instance, these silica sources would be acting as hydrophilic silica sources.

The at least one silica source may be added to the mixture as the product of hydrolysis and condensation. Hydrolysis and condensation of the silica source occurs by adding water and a catalyst to a solvent and adding the silica source at a time, intermittently or continuously, and conducting hydrolysis and condensation reactions while stirring the mixture at a temperature range generally from -30 to 100°C, preferably from 20 to 100°C, for 0 to 24 hours. The composition can be regulated to provide a desired solid content by conducting concentration or dilution with the solvent in each step of the preparation.

The hydrolysis and condensation of the silica source can occur at any point during the formation of the film, i.e., before adding to the mixture, after adding to the mixture, prior to or during curing, etc. For example, in certain embodiments of the present invention, the at least one silica source is combined with the solvent, water, and surfactant in a first vessel, the ionic additive and catalyst are combined in a second vessel, and the contents of the second vessel are gradually added to the first vessel and mixed. It is envisioned that a variety of different orders of addition to the mixture can be used without departing from the spirit of the present invention.

The catalyst suitable for the present invention includes any organic or inorganic acid or base that can catalyze the hydrolysis of substitutents from the silica source in the presence of water, and/or the condensation of two silica sources to form an Si-O-Si bridge. The catalyst can be an organic base such as, but not limited to, quaternary ammonium salts and hydroxides, such as ammonium or tetramethylammonium, amines such as primary, secondary, and tertiary amines, and amine oxides. The catalyst can also be an acid such as, but not limited to, nitric acid, maleic, oxalic, acetic, formic, glycolic, glyoxalic acid, or mixtures thereof. In preferred embodiments, the catalyst comprises nitric acid.

The term solvent as used herein refers to any liquid or supercritical fluid that provides solubility with the reagents, adjusts the film thickness, provides sufficient optical clarity for subsequent processing steps, such as lithography, and is substantially removed upon curing. Solvents that are suitable for the use in the present invention may include any solvent that, for example, exhibits solubility with the reagents, affects the viscosity of the mixture, and/or affects the surface tension of the mixture upon deposition onto the substrate. Solvents can be alcohol solvents, ketone solvents, amide solvents, or ester solvents. In certain embodiments, one or more solvents used in the present invention have relatively low boiling points, i.e., below 160°C. These solvents include, but are not limited to, tetrahydrofuran, acetone, 1,4-dioxane, 1,3-dioxolane, ethyl acetate, and methyl ethyl ketone. Other solvents, that can be used in the present invention but have boiling points above 160°C, include dimethylformamide, dimethylacetamide, N-methyl pyrrolidone, ethylene carbonate, propylene carbonate, glycerol and derivatives, naphthalene and substituted versions, acetic acid anyhydride, propionic acid and propionic acid anhydride, dimethyl sulfone, benzophenone, diphenyl sulfone, phenol, m-cresol, dimethyl sulfoxide, diphenyl ether, terphenyl, and the like. Preferred solvents include propylene glycol propyl ether (PGPE), 3-heptanol, 2-methyl-1-pentanol, 5-methyl-2-hexanol, 3-hexanol, 2-heptanol, 2-hexanol, 2,3-dimethyl-3-pentanol, propylene glycol methyl ether acetate (PGMEA), ethylene glycol n-butyl ether, propylene glycol n-butyl ether (PGBE), 1-butoxy-2-propanol, 2-methyl-3-pentanol, 2-methoxyethyl acetate, 2-butoxyethanol, 2-ethoxyethyl acetoacetate, 1-pentanol, and propylene glycol methyl ether. Still further exemplary solvents include lactates, pyruvates, and diols. Further exemplary solvents include those solvents listed in EP 1,127,929. The solvents enumerated above may be used alone or in combination of two or more solvents. In preferred embodiments, the solvent may comprise one or more solvents with relatively low boiling points, i.e., boiling points below 160°C. Still another suitable solvent includes supercritical $CO_2$.

The mixture used to form the films of the present invention preferably further comprises a porogen. A "porogen", as used herein, is a reagent that is used to generate void volume within the resultant film. Suitable porogens for use in the dielectric materials of the present invention include decomposable polymers, surfactants, dendrimers, hyper-branched polymers, polyoxyalkylene compounds, organic macromolecules, or combinations thereof. Still further examples of suitable porogens include those porogens described in pending patent application, Attorney Docket 06274P2, which is assigned to the assignee of the present invention.

The porogen could be a decomposable polymer. The decomposable polymer may be radiation decomposable, or more preferably, thermally decomposable. The term "polymer", as used herein, also encompasses the terms oligomers and/or copolymers unless expressly stated to the contrary. Radiation decomposable polymers are polymers that decompose upon exposure to radiation, e.g., ultraviolet, X-ray, electron beam, or the like. Desirable thermally decomposable polymers undergo thermal decomposition at temperatures that approach the condensation temperature of the silica source materials and are present during at least a portion of the cross-linking so that the silicate structure does not collapse when they leave. Such polymers are those which foster templating of the vitrification reaction, control and define pore size, and decompose and diffuses out of the matrix at the appropriate time in processing. Examples of these polymers include polymers that have an architecture that provides a three-dimensional structure such as, but not limited to, block copolymers, i.e., diblock, triblock, and multiblock copolymers; star block copolymers; radial diblock copolymers; graft diblock copolymers; cografted copolymers; dendrigraft copolymers; tapered block copolymers; and combinations of these architectures. Further examples of degradable polymers are found in U. S. Pat. No. 6,204,202.

The porogen of the present invention could also comprise a surfactant. For silica sol-gel based films in which the porosity is introduced by the addition of surfactant that is subsequently removed, varying the amount of surfactant can vary porosity. Typical surfactants exhibit an amphiphilic nature, meaning that they can be both hydrophilic and hydrophobic at the same time. Amphiphilic surfactants possess a hydrophilic head group or groups which have a strong affinity for water and a long hydrophobic tail which is organophilic and repels water. The surfactants can be anionic, cationic, nonionic, or amphoteric. Further classifications of surfactants include silicone surfactants, poly(alkylene oxide) surfactants, and fluorochemical surfactants. However, for the formation of dielectric layers for IC applications, non-ionic surfactants are generally preferred. The surfactants used in the present invention may not behave in the traditional sense, i.e., to form micelles or act as surface active agents. Suitable surfactants for use in the mixture include, but are not limited to, octyl and nonyl phenol ethoxylates such as TRITON® X-114, X-102, X-45, X-15; alcohol ethoxylates such as BRIJ® 56 ($C_{16}H_{33}(OCH_2CH_2)_{10}OH$) (ICI), BRIJ® 58 ($C_{16}H_{33}(OCH_2CH_2)_{20}OH$) (ICI), and acetylenics diols such as SURFYNOLS® 465 and 485 (Air Products and Chemicals, Inc.). Further surfactants include polymeric compounds such as the tri-block EO-PO-EO co-polymers PLURONIC® L121, L123, L31, L81, L101 and P123 (BASF, Inc.). Still further exemplary surfactants include alcohol (primary and secondary) ethoxylates, amine ethoxylates, glucosides, glucamides, polyethylene glycols, poly(ethylene glycolco-propylene glycol), or other surfactants provided in the reference McCutcheon's Emulsifiers and Detergents, North American Edition for the Year 2000 published by Manufacturers Confectioners Publishing Co. of Glen Rock, N.J.

It is preferred that the surfactants in the mixture have a metal content less than 20 ppm. While commercially available unpurified surfactants could be used, the final films may have impurity levels far in excess of acceptable levels, and thus the surfactant should be purified. Surfactant purification can be performed using common procedures, such as employment of ion exchange columns in which alkali ions can be retained and hydrogen ions released in their place. These unpurified surfactants may commonly possess alkali ion concentrations in the range from about 100 to 1000 parts per million. The goal of surfactant purification is to reduce alkali ion impurity levels to less than 50 parts per billion. Acceptable concentrations of alkali ion impurities within the film material are less than 10 parts per billion for each alkali element.

The porogen may be a hyper branched or dendrimeric polymer. Hyper branched and dendrimeric polymers generally have low solution and melt viscosities, high chemical reactivity due to surface functionality, and enhanced solubility even at higher molecular weights. Some non-limiting examples of suitable decomposable hyper-branched polymers and dendrimers are provided in "Comprehensive Polymer Science", 2nd Supplement, Aggarwal, pp. 71-132 (1996).

The porogen within the film-forming mixture may also be a polyoxyalkylene compound such as polyoxyalkylene non-ionic surfactants, polyoxyalkylene polymers, polyoxyalkylene copolymers, polyoxyalkylene oligomers, or combinations thereof. An example of such is a polyalkylene oxide that includes an alkyl moiety ranging from $C_2$ to $C_6$ such as polyethylene oxide, polypropylene oxide, and copolymers thereof.

In addition to the aforementioned ingredients, the film-forming mixture may also comprise an ionic additive. Ionic additives are added to mixture if the metal impurity content is about 500 ppm or less. Generally, the ionic additive is a compound chosen from a group of cationic additives of the general composition $[(NR_4)^+]_nA^{n-}$, where R can be a hydrogen atom or a monovalent organic group containing 1 to 24 carbon atoms, or mixtures of hydrogen atoms and/or monovalent organic groups, including tetramethylammonium and cetyltrimethylammonium, and $A^{n-}$ is an anion where n is the valence of the anion. Preferably, $A^{n-}$ may be chosen from the group consisting of formate, nitrate, oxalate, acetate, phosphate, carbonate, and hydroxide and combinations thereof. Tetramethylammonium salts, or more generally tetraalkylammonium salts, or tetraorganoammonium salts or organoamines in acidic media are added to surfactant templated porous oxide precursor formulations to increase the ionic content, replacing alkali ion impurities (sodium and potassium) removed during porogen purification.

Alternatively, the ionic additive may be an amine additive which forms an ionic ammonium type salt in the acidic precursor mixture. The suitable amine additive is selected from the group consisting of: triethylenediamine (TEDA); diethanolamine (DELA); triethanolamine, (TELA); aminopropyldiethanolamine (APDEA); bis(p-aminocyclohexyl)methane (PACM); quinuclidine (QUIN); 3-Quinuclidinol; trimethylamine (TMA); tetramethylethylendiamine, (TMEDA); tetramethyl-1,3-propanediamine (TMPDA); trimethylamine oxide (TMAO); PC-9, N,N,N-tris(N',N'-dimethyl-3-aminopropyl) amine; PC-77, 3,3'-bis(dimethylamino)-N-methyldipropylamine; CB, choline hydroxide; DMAP, 4-dimethylaminopyridine; DPA, diphenylamine; or TEPA, tetraethylenepentamine.

In embodiments where the film is formed through a spin-on approach, the mixture comprises, *inter alia,* at least one silica source, a porogen, a catalyst, and water. In certain preferred embodiments, the mixture further comprises a solvent, an ionic additive, and a surfactant. In brief, dispensing the mixture onto a substrate and evaporating the solvent and water can form the films. In certain preferred embodiments, the surfactant and remaining solvent and water may be removed by curing the coated substrate to one or more temperatures and for a time sufficient to produce the porous film.

The mixture may be deposited onto the substrate to form the coated substrate. The term substrate, as used herein, is any suitable composition that is formed before the dielectric film of the present invention is applied to and/or formed on that composition. Suitable substrates that may be used in conjunction with the present invention include, but are not limited to, semiconductor materials such as gallium arsenide ("GaAs"), silicon, and compositions containing silicon such as crystalline silicon, polysilicon, amorphous silicon, epitaxial silicon, silicon dioxide ("$SiO_2$"), and mixtures thereof. The mixture may be applied onto the substrate via a variety of methods including, but not limited to, dipping, rolling, brushing, spraying, or spin coating. The coated substrate may then be pre-heated to substantially complete the hydrolysis of the silica source, continue the crosslinking process, and drive off any remaining solvent, if present, from the film. In other embodiments such as CVD based methods, the mixture may be vaporized and/or form particulates that coat the substrate.

The coated substrate is then cured, preferably thermally cured, to substantially remove the porogen contained therein and form the porous film. Specific temperature and time durations will vary depending upon the ingredients within the mixture, the substrate, and the desired pore volume. The resultant porous film has a void fraction of 0.4 or greater, preferably 0.5 or greater, and more preferably 0.6 or greater. In certain embodiments, the thermal cure step is conducted at two or more temperatures rather than a controlled ramp or soak. The first temperature, typically below 300°C, may be to remove the water and/or solvent from the mixture and to further cross-linking reactions. The second temperature may be to remove the porogen and to substantially, but not necessarily completely, cross-link the material. In certain preferred embodiments of the present invention, the coated substrate is heated to one or more temperatures ranging from about 250 to about 450°C, or more preferably about 400°C or below. The heating or thermal cure step is conducted for a time of about 30 minutes or less, preferably about 15 minutes or less, and more preferably about 6 minutes or less.

The cure step is preferably conducted via thermal methods such as a hot plate, oven, furnace or the like. For thermal methods, the curing of the coated substrate may be conducted under controlled conditions such as atmospheric pressure using nitrogen, inert gas, air, or other $N_2/O_2$ mixtures (0-21% $O_2$), vacuum, or under reduced pressure having controlled oxygen concentration. Alternatively, the cure step may be conducted by electron-beam, ozone, plasma, X-ray, ultraviolet radiation or other means. Cure conditions such as time, temperature, and atmosphere may vary depending upon the method selected. In preferred embodiments, the curing step is conducted via a thermal method in an air, nitrogen, or inert gas atmosphere, under vacuum, or under reduced pressure having an oxygen concentration of 10% or lower.

The porous material or film of the present invention is further subjected to a post-cure treatment consisting of exposure to at least one ionizing radiation source to provide the dielectric film. Examples of suitable ionizing radiation sources include, but are not limited to, i.e., alpha-particles, beta-particles and gamma-rays from radioactive nuclei; x-rays; high energy electrons or mixtures thereof. This treatment may, for example, increase the mechanical integrity of the material or decrease the dielectric constant by reducing the amount of adsorbed water.

In certain preferred embodiments, the exposure step is conducted in an non-oxidizing atmosphere, i.e., conducted in an atmosphere having an oxygen concentration of 10,000 ppm or less, preferably 1,000 ppm or less. The exposure step is preferably conducted in a non-oxidizing atmosphere to minimize the chance of oxidation of the porous film which may cause an increase in dielectric constant. Examples of suitable non-oxidizing atmospheres include inert atmospheres (e.g., nitrogen, xenon, krypton, helium, argon, etc. or mixtures thereof), a reducing atmosphere (e.g., $H_2$, CO), or vacuum.

Specific temperature and time durations for the exposure step will vary depending upon the ingredients within the mixture, the substrate, the ionizing radiation source, and the desired pore volume. In certain preferred embodiments, the exposure step is conducted at a temperature below about 450°C, preferably below about 300°C, and more preferably below about 250°C. The exposure step is conducted for a time of about 30 minutes or less, preferably about 15 minutes or less, and more preferably about 6 minutes or less. In certain preferred embodiments, the exposure step is conducted for a time ranging from 1 to 5 minutes.

The exposure step may be conducted in a variety of settings depending upon the process used to form the porous film. It may be advantageous for the exposure step to be conducted after or even during at least a portion of the porous film formation (i.e., cure) step. For example, in one embodiment, an e-beam exposure may be conducted while the coated substrate is heated by a hot plate or similar means to cure the film. The exposure step can be performed in various settings such as, but not limited to, quartz vessel, a modified deposition chamber, a conveyor belt process system, a hot plate, a vacuum chamber, a cluster tool, a single wafer instrument, a batch processing instrument, or a rotating turnstile.

In certain preferred embodiments, the ionizing radiation source is an electron beam. Examples of different electron beam methods suitably for use in the process of the present invention include: S. Chattopadhyay et al., Journal of Materials Science, 36 (2001) 4323-4330; G. Kloster et al., Proceedings of IITC, June 3-5, 2002, SF, CA; and U.S. Pat. Nos. 6,207,555 B1, 6,204,201 B1 and 6,132,814 A1. The electron beam in the exposing step may comprise a singular beam or a cluster of beams. Electron beam post-treatment for selective removal of porogens or specific chemical species from an organosilicate film and/or improvement of film properties is conducted under the following conditions: the environment can be vacuum, inert (e.g., nitrogen, $CO_2$, noble gases (He, Ar, Ne, Kr, Xe), etc.), oxidizing (e.g., oxygen, air, dilute oxygen environments, enriched oxygen environments, ozone, nitrous oxide, etc.), or reducing (e.g., dilute or concentrated hydrocarbons, hydrogen, etc.). In embodiments wherein the electron beam treatment is conducted in an inert atmosphere, it is preferably a helium, argon, or nitrogen atmosphere. In embodiments wherein the electron beam treatment step is conducted under a vacuum, the degree of vacuum may range from 133 Pa or less, or preferably from 0.133 to 26.7 Pa. The temperature of the underlying substrate during electron beam exposure ranges from 25 to 450°C, preferably from 100 to 400° C. The total time for exposure to the electron beam may range from 0.001 to 30 minutes, preferably from 0.001 to 15 minutes, and more preferably from 1 to 5 minutes and may be continuous or pulsed.

The exposure to the electron beam is conducted at at an energy expressed via accelerating voltage preferably ranging from 1 to 17 keV in an irradiation dose of ranging from 1 to 10,000 $\mu C/cm^2$, preferably from 10 to 500 $\mu C/cm^2$. It is preferably to use lower accelerating voltages to avoid damage to the underlying semiconductor device.

The electron beam energy determines the electron beam penetration depth and ultimately the curing depth of the film. The mixture of the present invention contains a porogen to provide a porous film when cured. Consequently, lower electron beam accelerating voltages can be used; for instance, when the amount of porogen is sufficient to give a film with a dielectric constant of 2.2 or less, i.e., electron beam energies of less than 17 keV may be required for even the thickest films (3 $\mu$m). In embodiments wherein the density of the porous film is known, the relationship between electron beam penetration depth and electron, beam energy may be determined according to the Grun equation or Equation (5) as follows:

$$R_g = (0.046/d)V_a^{1.75} \qquad \text{Equation (5)}$$

In Equation (5), Rg is the range of electrons in the material ($\mu$m) or Grun range, d is the film density ($g/cm^3$), and $V_a$ is the accelerating voltage or electron energy (keV). For a given film thickness, porous films which have a lower density require lower e-beam energies to cure the film thereby decreasing the probability of the electron beam damaging the underlying semiconductor device. For example, a 10,000 Å thick, non-porous film having a density of 2.2 $g/cm^3$ may require an accelerating voltage of 9.1 keV accelerating voltage for curing whereas a compositionally identical 10,000 Å thick porous film having a wall density 2.2 $g/cm^3$ and a void fraction of 0.65 may require an accelerating voltage of 5.0 keV for curing. Similarily, a 5,000 Å thick, non-porous film having a density of 2.2 $g/cm^3$ may require an accelerating voltage of 6.1 keV accelerating voltage for curing whereas a compositionally identical 5,000 Å thick porous film having a wall density 2.2 $g/cm^3$ and a void fraction of 0.65 may require an accelerating voltage of 3.4 keV for curing.

The preferred dielectric films of the invention are mesoporous. The term "mesoporous", as used herein, describes pore sizes that range from about 10 Å to about 500 Å, preferably from about 10 Å to about 100 Å, and most preferably from about 10 Å to about 50 Å. It is preferred that the film have pores of a narrow size range and that the pores are homogeneously distributed throughout the film. Films of the invention preferably have a porosity of about 10% to about 90%, more preferably about 40% to about 85%. The porosity of the films may be closed or open pore, preferably open pore.

In certain embodiments of the present invention, the diffraction pattern of the film does not exhibit diffraction peaks at a d-spacing greater than 10 Angstroms. The diffraction pattern of the film may be obtained in a variety of ways such as, but not limited to, neutron, X-ray, small angle, grazing incidence, and reflectivity analytical techniques. For example, conventional x-ray diffraction data may be collected on a sample film using a conventional diffractometer such as a Siemens D5000 θ-θ diffractometer using CuKα radiation. Sample films may also be analyzed by X-ray reflectivity (XRR) data using, for example, a Rigaku ATX-G high-resolution diffraction system with Cu radiation from a rotating anode x-ray tube. Sample films may also be analyzed via small-angle neutron scattering (SANS) using, for example, a system such as the 30 meter NG7 SANS instrument at the NIST Center for Neutron Research.

The dielectric material of the present invention has mechanical properties that allow the material, when formed into a film, to resist cracking and enable it to be chemically/mechanically planarized. Further, the dielectric films of the present invention exhibit low shrinkage. Dielectric films of the present invention generally have a thickness that ranges from 0.05 to about 3 μm. Dielectric films of the present invention may exhibit a modulus of elasticity that ranges from about 0.5 to about 10 GPa, and generally between 2 and 6 GPa; a hardness value that ranges from about 0.2 to about 2.0 GPa, and generally from about 0.4 to about 1.2 GPa, and a refractive index determined at 633 nm of between 1.1 and 1.5.

The film of the present invention provides excellent insulating properties and a relatively high modulus of elasticity. The film also provides advantageous uniformity, dielectric constant stability, cracking resistance, and surface hardness. Suitable applications for the film of the present invention include interlayer insulating films for semiconductor devices such as LSIs, system LSIs, DRAMs, SDRAMs, RDRAMs, and D-RDRAMs, protective films such as surface coat films for semiconductor devices, interlayer insulating films for multilayered printed circuit boards, and protective or insulating films for liquid-crystal display devices. Further applications include capping layers, hard mask, or etch stops.

The invention will be illustrated in more detail with reference to the following examples, but it should be understood that the present invention is not deemed to be limited thereto.

In the following examples, unless stated otherwise, properties were obtained from sample films that were spun onto a low resistance (0.01 Ωcm) single crystal silicon wafer substrate and calcined to 400°C. The thickness, film refractive index, and porosity values of each film were determined by spectroscopic ellipsometry using a variable angle spectroscopic ellipsometer, Model SE 800 manufactured by Sentech Instruments GmbH, and calculated by SpectraRay software. The refractive index, film thickness, and percentage of air values were obtained by simulating the measurement using various models such as Bruggemann in the wavelength range from 400 to 800 nm with mean square error of about 1 or less. For the thickness values, the error between the simulated thickness and actual film thickness values measured by profilometry was generally less than 2%.

The dielectric constant of each sample film was determined according to ASTM Standard D150-98. The capacitance-voltage of each film were obtained at 1 MHz with a Solartron Model SI 1260 Frequency Analyzer and MSI Electronics Model Hg 401 single contact mercury probe. The error in capacitance measurements and mercury electrode area (A) was less than 1%. The substrate (wafer) capacitance ($C_{si}$), background capacitance ($C_b$) and total capacitance ($C_T$) were measured between +20 and -20 volts and the thin film sample capacitance ($C_s$) was calculated by Equation (6):

$$C_s = C_{SI} (C_T - C_b)/ [C_{SI} - (C_T - C_b)] \qquad \text{Equation (6)}$$

The dielectric constant of each film was calculated by Equation (7) wherein d is the film thickness, A is the mercury electrode area, and $\varepsilon_0$ is the dielectric constant in vacuum:

$$\varepsilon = \frac{C_s d}{\varepsilon_0 A} \qquad \text{Equation (7)}$$

The total error of the dielectric constant of the film was expected to be less than 6%.

The elastic modulus for each film was taken from $1 \times 0.4 \text{cm}^2$ samples cleaved from the center of the wafer and mounted onto an aluminum stub using a low-meltingtemperature adhesive, CRYSTALBOND® which is manufactured by Armco Products Inc., of Valley Cottage, N.Y. Indentation tests were performed on a NANOINDENTER® Dynamic Contact Module (DCM) manufactured by MTS Systems Corporation with an ACCUTIP™ Berkovich diamond tip using the continuous stiffness measurement ("CSM") method described in the reference, Oliver et al., "An Improved technique for Determining Hardness and Elastic Modulus Using Load and Displacement Sensing Indentation Experiments", J. Material Research, 1992, 7 [6], pp. 1564-1583. A small oscillation was superimposed on the primary loading signal and the resultant system response was analyzed by means of a frequencyspecific amplifier. The excitation frequency was held constant throughout the test at 75 Hz (DCM) and the excitation amplitude was controlled such that the resulting displacement amplitude remained constant at 1 nm (DCM).

Each indentation experiment allowed for a continuous measure of the contact stiffness, S. Using the dynamic measure of S, and established formulae for Young's modulus and hardness (Poisson's Ratio = 0.18 for silica, 0.25 for low κ films), every individual indentation experiment yielded Young's modulus and hardness as a continuous function of surface penetration. An array of 5 to 10 indents was performed on each sample and a distance of approximately 20 - 25 microns separated successive indents. The results from each indentation experiment were examined and any "outliers" were excluded. The results for Young's modulus and hardness vs. penetration for the indentation experiments of each sample were averaged using discrete displacement windows of approximately 5 nm. Using the data in this window, an average, standard deviation, and confidence interval for each sample were then calculated. The same statistics were likewise calculated for the rest of the discrete windows. Hardness results were obtained and averaged in the same manner. Hardness and Young's modulus were reported as the measured value of hardness at the minimum of the hardness curve (at about 30-50 nm) and the measured value of modulus at the minimum of the modulus curve (at about 30-50 nm). The errors of the modulus and the hardness of the film are expected to be less than 10 percent.

EXAMPLES

PURIFICATION OF REAGENTS

The reagents used in the following examples were analyzed via ICP/MS using a Finnigan Element 1, High resolution Inductively Coupled Plasma/Mass Spectrometer (ICP/MS), manufactured by Finnigan of Bremen, Germany, prior to addition to the reaction mixture. If the level of metal impurities in the reagent exceeded 50 ppb, the reagent was purified. Depending upon its composition, reagents were purified via standard procedures such as distillation under reduced pressure or ion exchange columns in which metal ions are retained in the column and hydrogen ions are released in its place. Table A provides the elemental analysis for a variety of different reagents, as received or after the purification process described herein.

If the reaction mixture included a surfactant, the surfactant purification procedure was conducted in the following manner. A quantity of surfactant such as AMBERLITE IR-120 resin was rinsed with high pressure liquid chromatography ("HPLC") grade water in its original container wherein the resin was floated for about 20 minutes. The resin was decanted and refilled as many times as needed to remove its deep color. A quantity of 2 Kg of resin was transferred to a 3.79 l (1 gallon) wide-mouth Nalgene bottle. The resin was rinsed with HPLC water, soaked for about 1 hour, and then filtered using a 2liter filter flask and a 17.8 cm (7") diameter Buchner funnel with Whatman Qualitive 1 filter paper. The filtered resin slurry was transferred to another 3.79 l (1 gallon) bottle. The rinse, soak, and filter steps were repeated until the water rinse was slightly yellow in color. The resin slurry was heated to a temperature of about 70°C. The heat-treated resin slurry was then filtered and the heating step was repeated until no color was observed in the filtrate. The heat-treated resin slurry was transferred to a dry 3.79 l (1-gallon) bottle where it is washed with about 1.5 L of 200 proof ethanol. The ethanol resin slurry was soaked at room temperature and filtered as before. The ethanol wash was repeated until no color remained in the filtrate.

The ethanol resin slurry was added to a 30" ion exchange column at about 1" from the top. The remainder of the column reservoir was filled with ethanol. The column was capped and inverted thereby filling the top reservoir of column with the resin and displacing air in the column tube with ethanol. The column was then inverted right side up while rotating the column to form a vortex of spinning ethanol. This process was continued until all resin has settled into the column. The packing step was repeated until no apparent channeling was observed. The ethanol in the column reservoir is allowed to drain into the column. The effluent is monitored for color bleed. The ethanol rinse was repeated until no color was evident. A regulating stopcock set the flow rate of effluent to 35 ml/min.

A solution of 10% surfactant in ethanol was prepared in 3.79 l (1-gallon) narrow mouth Nalgene container. An initial quantity of 300-500 ml of solution was passed through the 1st ion exchange column and the effluent was checked for color bleed and discarded. Additional quantities of solution were passed through the 1st ion exchange column and the remainder of the effluent was collected in another clean 3.79 l (1-gallon) narrow mouth container. The effluent from the 1st column was passed through the 2nd column ion exchange column and the effluent was collected after discarding the first 300 ml. The effluent was collected in either a 2 L round bottom flask (filling ½ full for rotovap procedure) or a clean (rinsed with 200 proof ethanol passed through ion exchange column) 3.79 l (1 gallon) narrow mouth bottle. This process was repeated until all of the surfactant solution has passed through the two columns to provide a purified surfactant ethanol solution.

The purified surfactant solution was rotovaped by using dry ice and acetone in condenser and vacuum trap using the slowest rotation speed and a slight crack in the vacuum line and water bath at room temperature. The vacuum level was adjusted until ethanol within the solution was condensed and no bumping was evident. The rotovapping process is continued in a water bath at 30°C by adding additional purified surfactant ethanol solution to purified surfactant in flask until all of column effluent solution has been rotovapped. The temperature of the bath was increased slowly to drive off residual ethanol. Afterwards, the bath temperature was increased to 60°C and rotovapping was continued until all ethanol has been removed to yield the purified surfactant. A small sample of the purified surfactant was analyzed for metal content using ICP-MS prior to use.

Example: E-beam Treatment of Silica-based Low-k Dielectric Films

Three different reaction mixtures were prepared using the reagents and quantities provided in Table I. Each of these reaction mixtures were deposited via a spin on deposition methods onto a 200mm Si wafer with 150Å thermal oxide (R< 0.02 ohm-cm) using aTAZMO model #SW12132HM machine. A 3ml volume of the reaction mixture was dispensed onto the wafer rotating at a speed of 200 revolutions per minute (rpm) and then spun at 1800 rpm to provide four films. After deposition, the films were thermally cured in an ambient atmosphere on a hot plate for 60 seconds, 60 seconds, and 180 seconds at a temperature of 90°C, 140°C, and 400°C, respectively. The thickness, refractive index, dielectric constant, and hardness for each film is provided in Table II.

The films were subjected to exposure to electron beam. Typical parameters for electron beam exposure may be as follows: wafer maintained at a temperature of 100°C, time of e-beam exposure was 60 seconds, using a 2keV beam at a dosage of 100 $\mu$C/cm2. The thickness, dielectric constant, and elastic modulus for each film after electron beam exposure is provided in Table II. The value of the normalized wall elastic modulus ($E_0'$) for each film was determined from the values of elastic modulus (E) and dielectric constant (k) for the films using Equation 4 disclosed herein and applying the rearranged Maxwell's equation (Equation 1) and a matrix k of 4.2. Figure 1 illustrates the relationship between the elastic modulus and dielectric constant for each film prior to and after exposure to electron beam. As both Table II and Figure 1 illustrate, the dielectric films after exposure to electron beam had lower dielectric constants and higher elastic modulus relative to the porous films that were not subjected to the electron beam. Thus, the electron beam exposure improved the mechanical properties of the porous film.

Table I

| Example | TEOS (g) | MTES (g) | PGPE (g) | Triton X- 114(g) | 0.1 M HNO3 (g) | 2.4 wt% TMAH (g) |
|---------|----------|----------|----------|------------------|----------------|------------------|
| Ex.1 | 22.5 | 22.5 | 87 | 5.0 | 24 | 1 |
| Ex.2 | 22.5 | 22.5 | 90 | 6.5 | 24 | 1 |
| Ex.3 | 22.5 | 22.5 | 90 | 9.67 | 24 | 1 |

Table II

| Example | Thickness, $\mu$m | Refractive Index | Dielectric Constant | Elastic Modulus (GPa) | Hardness (GPa) | $E_0'$ (GPa) |
|---------|-------------------|------------------|---------------------|-----------------------|----------------|--------------|
| Ex.1a: no e-beam exposure | 4196 | 1.277 | 3.01 | 6.48±0.46 | 1.14±0.11 | 15.1 |
| Ex. 2a: no e-beam exposure | 4300 | 1.292 | 2.88 | 4 | 0.7 | 10.5 |
| Ex. 2b: e-beam exposed | 3896 | 1.269 | 2.34 | 9.08±0.17 | 1.40±0.08 | 43.4 |
| Ex. 2c: no e-beam exposure | 4668 | 1.274 | 2.68 | 3.81±0.28 | 0.60±0.09 | 12.1 |
| Ex. 2d: e-beam exposed | 4269 | 1.28 | 2.38 | 9 | 1.4 | 40.7 |
| Ex. 3a: no e-beam exposure | 4256 | 1.224 | 2.24 | 2.948 | 0.358 | 16.3 |
| Ex. 3b: e-beam exposed | 3846 | 1.215 | 2.17 | 5.6 | 0.6±0.2 | 34.6 |

The application is further characterized by the following clauses:

1. A mixture for forming a porous, silica-based material having a dielectric constant of about 2.2 or less, comprising:

at least one silica source having an at least one silicon atom and an organic group, comprising carbon and hydrogen atoms, attached thereto wherein at least one hydrogen atom within the organic group is removable upon exposure to an ionizing radiation source; and

at least one porogen wherein the ratio of the weight of at least one porogen to the weight of the at least one porogen and the weight of $SiO_2$ provided by the at least one silica source is 0.4 or greater.

2. The mixture of clause 1 having a metal impurity content of about 500 ppm or less.

3. The mixture of clause 2 further comprising an ionic additive.

4. The mixture of clause 1 further comprising a solvent.

5. The mixture of clause 1 further comprising water.

6. The mixture of clause 1 wherein the organic group comprises an alkyl group wherein the alkyl group has from 1 to 6 carbon atoms.

7. The mixture of clause 6 wherein the organic group comprises a methyl group.

8. The mixture of clause 7 wherein the molar ratio of the methyl group to silicon is 0.2 or greater.

9. The mixture of clause 8 wherein the molar ratio of the methyl group to silicon is 0.6 or greater.

10. The mixture of clause 6 wherein the organic group comprises a neopentyl group.

11. The mixture of clause 1 wherein the at least one silica source is a product of hydrolysis and condensation of one or more silane compounds selected from the group of compounds represented by the following formulas:

i. $R_aSi(OR^1)_{4-a}$, wherein R and $R^1$ can be independently the same or different; R represents a hydrogen atom or a monovalent organic group; $R^1$ represents a monovalent organic group; and a is an integer that ranges from 1 to 3;

ii. $R^3{}_b(R^4O)_{3-b}Si\text{-}(R^7)\text{-}Si(OR^5)_{3-c}R^6{}_c$, wherein $R^3$ and $R^6$ can be independently the same or different and each represents a hydrogen atom or a monovalent organic group; $R^4$ and $R^5$ can be independently the same or different and each represents a monovalent organic group; b and c can be independently the same or different and each is a number ranging from 0 to 3; $R^7$ represents an oxygen atom, a phenylene group, or a group represented by $\text{-}(CH_2)_n\text{-}$, wherein n is an integer ranging from 1 to 6; or combinations thereof.

12. The mixture of clause 11 wherein the mixture further comprises a product of hydrolysis and condensation of one or more silane compounds selected from the group of compounds represented by the following formulas

i. $Si(OR^2)_4$, where $R^2$ represents a monovalent organic group;

ii. $R_aSi(OR^1)_{4-a}$, wherein R represents a hydrogen atom; $R^1$ represents a monovalent organic group; and a is an integer that ranges from 1 to 3;

iii. $R^3{}_b(R^4O)_{3-b}Si\text{-}O\text{-}Si(OR^S)_{3-c}R^6{}_c$, wherein $R^3$ and $R^6$ represents a hydrogen atom; $R^4$ and $R^5$ can be independently the same or different and each represents a monovalent organic group; b and c can be independently the same or different and each is a number ranging from 0 to 3; or combinations thereof.

13. The mixture of clause 11 wherein the mixture further comprises a catalyst.

14. The mixture of clause 13 wherein the catalyst comprises a non-halide containing acid catalyst.

15. The silica-based material produced from the mixture of clause 1.

16. The material of clause 15 wherein the diffraction pattern of the material does not exhibit diffraction peaks at a d-spacing greater than 10 Angstroms.

17. The material of clause 15 wherein the diffraction pattern of the material exhibits diffraction peaks at a d-spacing greater than 10 Angstroms.

18. The material of clause 15 wherein the normalized wall elastic modulus ($E_0$'), derived in part from the dielectric constant of the material, is about 16 GPa or greater.

19. The material of clause 18 wherein the normalized wall elastic modulus ($E_0$'), derived in part from the dielectric constant of the material, is about 22 GPa or greater.

20. The material of clause 19 wherein the normalized wall elastic modulus ($E_0$'), derived in part from the dielectric constant of the material, is about 34 GPa or greater.

21. The material of clause 15 wherein the dielectric constant is 2.1 or less.

22. A process for forming a dielectric film having a dielectric constant of 2.2 or less, the process comprising:

providing a mixture comprising an at least one silica source having an at least one silicon atom and an organic group, comprising carbon and hydrogen atoms, bonded thereto and at least one porogen;

depositing the mixture onto a substrate to form a coated substrate;

curing the coated substrate with one or more energy sources for a time and at least one temperature sufficient to remove at least a portion of the porogen and form a porous film; and

exposing the porous film to an ionizing radiation source sufficient to remove at least a portion of the hydrogen atoms within the porous film and provide the dielectric film.

23. The process of clause 22 wherein the energy source in the curing step is at least one selected from the group consisting of a thermal source, α-particles, β-particles, γ-rays, x-rays, high energy electron, electron beam, ultraviolet light, visible light, infrared light, microwave, radio-frequency wavelengths, plasma, or mixtures thereof.

24. The process of clause 22 wherein the ionizing radiation source in the exposing step is at least one selected from the group consisting of α-particles, β-particles, γ-rays, x-rays, high energy electron, electron beam, or mixtures thereof.

25. The process of clause 24 wherein the ionizing radiation source is an electron beam.

26. The process of clause 25 wherein the accelerating voltage of the electron beam is 17 kV or less.

27. The process of clause 26 wherein the accelerating voltage of the electron beam is 10 kV or less.

28. The process of clause 22 wherein the curing step is conducted at a temperature of 450°C or less.

29. The process of clause 28 wherein the curing step is conducted at a temperature of 400°C or less.

30. The process of clause 22 wherein the curing step is conducted for a time of about 30 minutes or less.

31. The process of clause 30 wherein the curing step is conducted for a time of about 15 minutes or less.

32. The process of clause 31 wherein the curing step is conducted for a time of about 6 minutes or less.

33. The process of clause 22 wherein at least a portion of the curing step is conducted during at least a portion of the exposing step.

34. The process of clause 22 wherein the temperature of the substrate during the exposing step ranges from 100 to 450°C.

35. A dielectric film formed by the process of clause 22.

36. The dielectric film of clause 35 wherein the dielectric film has one or more bond types selected from the group consisting of silicon-carbon bonds, carbon-carbon bonds, silicon-oxygen bonds, and silicon-hydrogen bonds.

37. The film of clause 35 wherein the diffraction pattern of the material does not exhibit diffraction peaks at a d-spacing greater than 10 Angstroms.

38. The film of clause 35 wherein the diffraction pattern of the material does exhibit diffraction peaks at a d-spacing greater than 10 Angstroms.

39. The film of clause 35 wherein the normalized wall elastic modulus ($E_0'$), derived in part from the dielectric constant of the material, is about 16 GPa or greater.

40. The film of clause 39 wherein the normalized wall elastic modulus ($E_0'$), derived in part from the dielectric constant of the material, is about 22 GPa or greater.

41. The film of clause 40 wherein the normalized wall elastic modulus ($E_0'$), derived in part from the dielectric constant of the material, is about 34 GPa or greater.

42. The film of clause 35 wherein the dielectric constant is 2.1 or less.

43. The dielectric film of clause 35 wherein the dielectric film is an insulation layer, an interlayer dielectric layer, an intermetal dielectric layer, a capping layer, a chemical mechanical planarization layer, a barrier layer, or an adhesion layer within an integrated circuit.

44. A process for forming a dielectric material comprising exposing a porous material comprising an at least one silica source having an at least one silicon atom and an organic group comprising carbon and hydrogen atoms attached thereto to an ionizing radiation source sufficient to remove at least a portion of the hydrogen atoms within the porous film and provide the dielectric material wherein the dielectric material has one or more bond types selected from the group consisting of silicon-carbon bonds, carbon-carbon bonds, silicon-oxygen bonds, and silicon-hydrogen bonds.

45. The process of clause 44 wherein the porous material has a void fraction of greater than 0.4.

46. The process of clause 45 wherein the porous material has a void fraction of greater than 0.5.

47. The process of clause 46 wherein the porous material has a void fraction of greater than 0.6.

48. The process of clause 44 wherein the ionizing radiation source is an electron beam.

49. The process of clause 48 wherein the accelerating voltage of the electron beam is 17 kV or less.

50. The process of clause 44 wherein the normalized wall elastic modulus ($E_0'$) of the dielectric material, derived in part from the dielectric constant of the material, is about 16 GPa or greater.

51. The process of clause 50 wherein the normalized wall elastic modulus ($E_0'$) of the dielectric material, derived in part from the dielectric constant of the material, is about 22 GPa or greater.

52. The process of clause 51 wherein the normalized wall elastic modulus ($E_0$') of the dielectric material, derived in part from the dielectric constant of the material, is about 32 GPa or greater.

53. The process of clause 52 wherein the normalized wall elastic modulus ($E_0$') of the dielectric material, derived in part from the dielectric constant of the material, is about 37 GPa or greater.

54. The process of clause 44 wherein the dielectric material has carbon-carbon bonds.

55. A mixture for forming a porous, silica-based material having a dielectric constant ranging from 2.1 to 3.7 and a normalized wall elastic modulus ($E_0$'), derived in part from the dielectric constant of the material, of about 32 GPa or greater, comprising:

at least one silica source having an at least one silicon atom and an organic group comprising carbon and hydrogen atoms attached thereto wherein at least one hydrogen atom within the organic group is removable upon exposure to an ionizing radiation source; and

at least one porogen wherein the ratio of the weight of at least one porogen to the weight of the at least one porogen and the weight of $SiO_2$ provided by the at least one silica source is 0.15 or greater.

56. The mixture of clause 55 wherein the normalized wall elastic modulus of the material is about 37 GPa or greater.

57. The mixture of clause 55 wherein the dielectric constant of the material is greater than 2.4.

58. A process for forming a dielectric film having a dielectric constant ranging from 2.2 to 3.7, the process comprising:

providing a mixture comprising an at least one silica source having an at least one silicon atom and an organic group, comprising carbon and hydrogen atoms, bonded thereto and at least one porogen;

depositing the mixture onto a substrate to form a coated substrate;

curing the coated substrate with one or more energy sources for a time and at least one temperature sufficient to remove at least a portion of the porogen and form a porous film; and

exposing the porous film to an ionizing radiation source sufficient to remove at least a portion of the hydrogen atoms within the porous film and provide the dielectric film.

59. The process of clause 58 wherein the normalized wall elastic modulus ($E_0$') of the dielectric material, derived in part from the dielectric constant of the material, is about 32 GPa or greater.

## Claims

1. A process for forming a dielectric film having a dielectric constant ranging from 2.1 to 3.7, the process comprising:

providing a mixture comprising an at least one silica source and at least one porogen, wherein the at least one silica source comprises at least one silicon atom having an organic group bonded thereto, wherein the organic group comprises carbon and hydrogen atoms, and wherein a mole ratio of Si-C bonds to total number of Si atoms in the at least one silica source is 0.2 or greater;

depositing the mixture onto a substrate to form a coated substrate;

curing the coated substrate with one or more energy sources for a time and at least one temperature sufficient to remove at least a portion of the porogen and form a porous film; and

exposing the porous film to an ionising radiation source sufficient to remove at least a portion of the hydrogen atoms within the porous film and provide the dielectric film, wherein the normalized wall elastic modulus ($E_0$') of the dielectric film, derived in part from the dielectric constant of the film, is about 32 GPa or greater.

2. The process of claim 1 wherein the energy source in the curing step is at least one selected from the group consisting of a thermal source, $\alpha$-particles, $\beta$-particles, $\gamma$-rays, x-rays, high energy electron, electron beam, ultraviolet light, visible light, infrared light, microwave, radio-frequency wavelengths, plasma, or mixtures thereof.

3. The process of claim 1 wherein the curing step is conducted at a temperature of 450°C or less.

4. The process of claim 3 wherein the curing step is conducted at a temperature of 400°C or less.

5. The process of claim 1 wherein the curing step is conducted for a time of about 30 minutes or less.

6. The process of claim 5 wherein the curing step is conducted for a time of about 15 minutes or less.

**7.** The process of claim 6 wherein the curing step is conducted for a time of about 6 minutes or less.

**8.** The process of claim 1 wherein at least a portion of the curing step is conducted during at least a portion of the exposing step.

**9.** The process of claim 1 wherein the ionizing radiation source in the exposing step is at least one selected from the group consisting of $\alpha$-particles, $\beta$-particles, $\gamma$-rays, x-rays, high energy electron, electron beam, or mixtures thereof.

**10.** The process of claim 9 wherein the ionization radiation source is an electron beam.

**11.** The process of claim 10 wherein the accelerating voltage of the electron beam is 17 keV or less.

**12.** The process of claim 11 wherein the accelerating voltage of the electron beam is 10 keV or less.

**13.** The process of claim 1 wherein the temperature of the substrate during the exposing step ranges from 100 to 450°C.

**14.** The process of claim 1 wherein the normalized wall elastic modulus ($E_0'$) of the dielectric film, derived in part from the dielectric constant of the film, is about 37 GPa or greater

**Patentansprüche**

**1.** Verfahren zum Erzeugen eines dielektrischen Films mit einer Dielektrizitätskonstante im Bereich von 2,1 bis 3,7, wobei das Verfahren umfaßt:

Bereitstellen eines Gemischs, das zumindest eine Siliciumdioxidquelle und zumindest ein Porogen umfaßt, wobei die zumindest eine Siliciumdioxidquelle zumindest ein Siliciumatom mit einem daran gebundenen organischen Rest umfaßt, wobei der organische Rest Kohlenstoff- und Wasserstoffatome umfaßt, und wobei das Molverhältnis zwischen den Si-C-Bindungen und der Gesamtzahl der Si-Atome in der zumindest einen Siliciumdioxidquelle 0,2 oder mehr beträgt;
Auftragen des Gemischs auf ein Substrat, so daß ein beschichtetes Substrat entsteht;
Härten des beschichteten Substrats mit einer oder mehreren Energiequellen für einen Zeitraum und bei zumindest einer Temperatur, die ausreichen, um zumindest einen Teil des Porogens zu entfernen und einen porösen Film zu bilden; und
Aussetzen des porösen Films einer Quelle für ionisierende Strahlung, was ausreicht, um zumindest einen Teil der Wasserstoffatome innerhalb des porösen Films zu entfernen und den dielektrischen Film bereitzustellen, wobei der normierte Elastizitätsmodul ($E_0'$) der Wand des dielektrischen Films, der teilweise von der Dielektrizitätskonstante des Films abgeleitet ist, etwa 32 GPa oder mehr beträgt.

**2.** Verfahren nach Anspruch 1, wobei die Energiequelle beim Schritt des Härtens zumindest eine ist, die aus der Gruppe ausgewählt ist, die aus einer Wärmequelle, $\alpha$-Teilchen, $\beta$-Teilchen, $\gamma$-Strahlen, Röntgenstrahlen, energiereichen Elektronen, Elektronenstrahlen, UV-Licht, sichtbarem Licht, IR-Licht, Mikrowellen, Hochfrequenz-Wellenlängen, Plasma oder Gemischen davon besteht.

**3.** Verfahren nach Anspruch 1, wobei der Schritt des Härtens bei einer Temperatur von 450°C oder weniger erfolgt.

**4.** Verfahren nach Anspruch 3, wobei der Schritt des Härtens bei einer Temperatur von 400°C oder weniger erfolgt.

**5.** Verfahren nach Anspruch 1, wobei der Schritt des Härtens für einen Zeitraum von etwa 30 Minuten oder weniger erfolgt.

**6.** Verfahren nach Anspruch 5, wobei der Schritt des Härtens für einen Zeitraum von etwa 15 Minuten oder weniger erfolgt.

**7.** Verfahren nach Anspruch 6, wobei der Schritt des Härtens für einen Zeitraum von etwa 6 Minuten oder weniger erfolgt.

**8.** Verfahren nach Anspruch 1, wobei zumindest ein Teil des Schritts des Härtens während zumindest eines Teils des Bestrahlungsschrittes erfolgt.

**9.** Verfahren nach Anspruch 1, wobei die Quelle für ionisierende Strahlung beim Bestrahlungsschritt zumindest eine ist, die aus der Gruppe von α-Teilchen, β-Teilchen, γ-Strahlen, Röntgenstrahlen, energiereichen Elektronen, Elektronenstrahlen oder Gemischen davon ausgewählt ist.

**10.** Verfahren nach Anspruch 9, wobei die Quelle für ionisierende Strahlung ein Elektronenstrahl ist.

**11.** Verfahren nach Anspruch 10, wobei die Beschleunigungsspannung des Elektronenstrahls 17 keV oder weniger beträgt.

**12.** Verfahren nach Anspruch 11, wobei die Beschleunigungsspannung des Elektronenstrahls 10 keV oder weniger beträgt.

**13.** Verfahren nach Anspruch 1, wobei die Temperatur des Substrats während des Bestrahlungsschritts im Bereich von 100 bis 450°C liegt.

**14.** Verfahren nach Anspruch 1, wobei der normierte Elastizitätsmodul ($E_0$') der Wand des dielektrischen Films, der teilweise von der Dielektrizitätskonstante des Films abgeleitet ist, etwa 37 GPa oder mehr beträgt.

**Revendications**

**1.** Procédé pour la production d'un film diélectrique ayant une constante diélectrique variant de 2,1 à 3,7, le procédé comprenant :

la fourniture d'un mélange comprenant au moins une source de silice et au moins un agent porogène, dans lequel l'au moins une source de silice comprend au moins un atome de silicium comportant un groupe organique lié à celui-ci, dans lequel le groupe organique comprend des atomes de carbone et d'hydrogène, et dans lequel le rapport molaire des liaisons Si-C au nombre total d'atomes de Si dans l'au moins une source de silice est de 0,2 ou plus ;
le dépôt du mélange sur un substrat pour former un substrat revêtu ;
le durcissement du substrat revêtu avec une ou plusieurs sources d'énergie pendant une durée et à au moins une température suffisantes pour éliminer au moins une portion de l'agent porogène et former un film poreux ; et
l'exposition du film poreux à une source de radiation ionisante suffisante pour éliminer au moins une partie des atomes d'hydrogène dans le film poreux, et produire le film diélectrique, dans lequel le module d'élasticité de paroi normalisé ($E_0$') du film diélectrique, partiellement dérivé de la constante diélectrique du film, est d'environ 32 GPa ou plus.

**2.** Procédé de la revendication 1, dans lequel la source d'énergie dans l'étape de durcissement comprend au moins une source choisie parmi le groupe consistant en une source thermique, les particules α, les particules β, les rayons γ, les rayons X, les électrons de haute énergie, un faisceau d'électrons, la lumière ultraviolette, la lumière visible, la lumière infrarouge, les micro-ondes, les longueurs d'onde de radiofréquence, un plasma ou les combinaisons de ceux-ci.

**3.** Procédé de la revendication 1, dans lequel l'étape de durcissement est effectuée à une température de 450 °C ou moins.

**4.** Procédé de la revendication 3, dans lequel l'étape de durcissement est effectuée à une température de 400 °C ou moins.

**5.** Procédé de la revendication 1, dans lequel l'étape de durcissement est effectuée pendant un temps d'environ 30 minutes ou moins.

**6.** Procédé de la revendication 5, dans lequel l'étape de durcissement est effectuée pendant un temps d'environ 15 minutes ou moins.

**7.** Procédé de la revendication 6, dans lequel l'étape de durcissement est effectuée pendant un temps d'environ 6 minutes ou moins.

**8.** Procédé de la revendication 1, dans lequel au moins une partie de l'étape de durcissement est effectuée au cours d'au moins une partie de l'étape d'exposition.

**9.** Procédé de la revendication 1, dans lequel la source de radiation ionisante dans l'étape d'exposition comprend au moins une source choisie parmi le groupe consistant en les particules α, les particules β, les rayons γ, les rayons X, les électrons de haute énergie, un faisceau d'électrons ou des combinaisons de ceux-ci.

**10.** Procédé de la revendication 9, dans lequel la source de radiation ionisante est un faisceau d'électrons.

**11.** Procédé de la revendication 10, dans lequel la tension d'accélération du faisceau d'électrons est de 17 keV ou moins.

**12.** Procédé de la revendication 11, dans lequel la tension d'accélération du faisceau d'électrons est de 10 keV ou moins.

**13.** Procédé de la revendication 1, dans lequel la température du substrat au cours de l'étape d'exposition varie de 100 à 450 °C.

**14.** Procédé de la revendication 1, dans lequel le module d'élasticité de paroi normalisé ($E_o'$) du film diélectrique, partiellement dérivé de la constante diélectrique du film, est d'environ 37 GPa ou plus.

**MesoEl k Film k-E**

FIGURE 1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6042994 A
- WO 9700535 A
- US 6132814 A
- US 20010018129 A
- EP 1369907 A
- EP 1376671 A
- US 158511 A
- US 6171945 B
- US 6054206 A

- US 6258407 B
- US 6271273 B
- EP 1088868 A
- EP 1123753 A
- EP 1127929 A
- US 6204202 B
- US 6207555 B1
- US 6204201 B1
- US 6132814 A1

**Non-patent literature cited in the description**

- **WANG et al.** Advanced processing: CMP of Cu/low-K and Cu/ultralow-K layers. *Solid State Technol.,* September 2001
- **LIN et al.** Low- k Dielectrics Characterization for Damascene Integration. *International Interconnect Technology Conference,* June 2001
- **HAY et al.** Synthesis of Organic-Inorganic Hybrids via the Non-hydrolytic Sol-Gel Process. *Chem. Mater,* 2001, vol. 13, 3396-3403
- **HAY et al.** A Versatile Route to Organically-Modified Silicas and Porous Silicas via the Non-Hydrolytic Sol-Gel Process. *J. Mater. Chem.,* 2000, vol. 10, 1811-1818

- McCutcheon's Emulsifiers and Detergents. Manufacturers Confectioners Publishing Co, 2000
- *Comprehensive Polymer Science,* 1996, 71-132
- **S. CHATTOPADHYAY et al.** *Journal of Materials Science,* 2001, vol. 36, 4323-4330
- **G. KLOSTER et al.** *Proceedings of IITC,* 03 June 2002
- **OLIVER et al.** An Improved technique for Determining Hardness and Elastic Modulus Using Load and Displacement Sensing Indentation Experiments. *J. Material Research,* 1992, vol. 7 (6), 1564-1583